# EUROPEAN PATENT APPLICATION

(11) **EP 4 838 402 A1**
(43) Date of publication of application: **11.11.2026**
(21) Application number: 26174538.4
(22) Date of filing: 24.04.2026
(51) Int. Cl.: G06F 30/32, G06F 8/30, G06F 8/41, G06F 30/323, G06F 30/327, G06F 30/30, G06F 40/205, G06F 40/211

(54) **GENERATING A HARDWARE DESCRIPTION FOR CONFIGURING A DIGITAL ELECTRONIC CIRCUIT TO PARSE DATA ACCORDING TO AN LL(*) GRAMMAR**

(30) Priority: 09.05.2025 GB 202507181
(71) Applicant: Garrison Technology Ltd, London SE1 8UL (GB)
(72) Inventor: FROSZTEGA, Edward, London, SE1 8UL (GB); STOECKIGT, Stefan, London, SE1 8UL (GB)
(74) Representative: Reddie & Grose LLP

(57) **Abstract**

Generating a hardware description for configuring a digital electronic circuit, such as an application-specific integrated circuit (ASIC) or a field-programmable gate array (FPGA), wherein the hardware description configures the digital electronic circuit to parse input data comprising a sequence of input tokens against an LL(*) grammar. This is achieved by implementing a recursive transition network (RTN) or an augmented transition network (ATN) representing the grammar within the digital electronic circuit. When the grammar defines a data format, such as a JSON schema, XML Schema Definition (XSD), or ASN.1 schema, a document can be validated against the data format by the configured digital electronic circuit processing the document as the input data.

## Description

### TECHNICAL FIELD

This disclosure relates to generating a hardware description for configuring a digital electronic circuit to parse input data comprising a sequence of input tokens against an LL(*) grammar that defines a data format. This disclosure also relates to a method of configuring a digital electronic circuit to parse input data, and a digital electronic circuit configured accordingly.

### BACKGROUND

Security concerns arise in applications where datasets obtained from untrusted sources are processed. For example, when data is processed, malicious code or the like could be hidden within the data, which could lead to a security breach in the computer system processing the data. One particular concern is that the data may include malicious code that could cause the processing device to execute arbitrary code.

One way to mitigate such risks is to validate data before subsequent processing, wherein the data is validated against a particular expected data format, for example a schema, such as a JSON Schema, XML Schema Definition (XSD), or ASN.1 schema. This confirms that the data conforms to the schema, and thus reduces the risk of any malicious code being included within the data, because it is unlikely that such malicious code would conform to the schema.

One way to validate data to a data format is by parsing. For example, data may be parsed using parsing software run on a general-purpose computer. The parsing software processes all of the data and compares it to what is permitted according to the data format. If the parsing software is able to fully parse the data, then the data is confirmed to accord with the data format. If the parsing software fails to parse the data fully, then the data does not accord with the data format. The ANTLR software tool (Another Tool for Language Recognition; see https://www.antlr.org/) may be used in the software parsing process. The ANTLR software tool takes, as input, a grammar that specifies a language and outputs source code for a recognizer of that language. It can therefore be used with a grammar specifying a data format to generate source code for a recognizer of that data format.

### SUMMARY

This disclosure relates generally to generating a hardware description for configuring a digital electronic circuit, such as an application-specific integrated circuit (ASIC) or a field-programmable gate array (FPGA), wherein the hardware description configures the digital electronic circuit to parse input data comprising a sequence of input tokens against an LL(*) grammar. This is achieved by implementing a recursive transition network (RTN) or an augmented transition network (ATN) representing the grammar within the digital electronic circuit. When the grammar defines a data format, such as a JSON schema, XML Schema Definition (XSD), or ASN.1 schema, a document can be validated against the data format by the configured digital electronic circuit processing the document as the input data.

In accordance with an aspect of this disclosure, there is provided a computer-implemented method of generating a hardware description for configuring a digital electronic circuit to parse input data against an LL(*) grammar that defines a data format, the input data comprising a sequence of input tokens, the method comprising: providing a digitally stored graph representing a transition network based on the rules of the LL(*) grammar, and generating the hardware description in a hardware description language or as a netlist based on the transition network. The LL(*) grammar is not LL(1).

The transition network comprises a plurality of networks including at least one embedded network that is embedded within at least one other network of the transition network. Each of the one or more networks comprises a plurality of vertices and a plurality of directed edges connected between vertices of the network, the plurality of vertices including a start vertex and an end vertex, each directed edge connected between a respective source vertex and destination vertex of the network. The plurality of directed edges of the one or more networks comprises a plurality of input-consuming edges and a plurality of non-input-consuming edges. Each input-consuming edge represents a transition between its source vertex and its destination vertex conditional on a current input token of the input data matching an input-consumption condition associated with the input-consuming edge, wherein parsing of the input data advances to a next input token of the input data with the transition. Each non-input-consuming edge represents a transition between its source vertex and its destination vertex without the parsing of the input data advancing to a next input token of the input data with the transition.

Each network within which an embedded network is embedded comprises at least one embedded-network-calling edge and corresponding embedded-network-returning edge, which are non-input-consuming edges. For each embedded-network-calling edge and corresponding embedded-network-returning edge, the source vertex of the embedded-network-calling edge and destination vertex of the embedded-network-returning edge are vertices of a network within which the embedded network is embedded, the destination vertex of the embedded-network-calling edge is the start vertex of the embedded network, and the source vertex of the embedded-network-returning edge is the end vertex of the embedded network.

The transition network is such that for all input data that conforms to the LL(*) grammar, during parsing of the input data against the grammar, after a first embedded-network-calling edge to any embedded network within the transition network is transitioned, no embedded-network-calling edges to that embedded network are subsequently transitioned until either the embedded-network-returning edge corresponding to the first embedded-network-calling edge has been transitioned or the parse reaches a state where no input-consuming edge within that embedded network can be transitioned for the next input token.

Generating the hardware description comprises implementing an input buffer in the hardware description to store a sequence of input tokens of the input data, the input buffer configured to provide an input token of the sequence of input tokens as output from the input buffer, wherein the input buffer is further configured to sequentially advance through the sequence of input tokens by, on a clock tick, providing a next input token as output from the input buffer. Generating the hardware description comprises further implementing circuitry in the hardware description for the edges and vertices of the transition network, wherein the implemented circuitry for each vertex is electrically connected to the implemented circuitry for each edge that is connected to the vertex in the transition network, the implemented circuitry for each vertex configured to output a logical high to circuitry for all outgoing directed edges of that vertex if circuitry for an incoming directed edge of that vertex provides a logical high.

The implemented circuitry for each input-consuming edge comprises a register with associated logic configured to compare an input token provided as output from the input buffer with the input-consumption condition associated with that input-consuming edge, the register with associated logic configured to, if the implemented circuitry for the source vertex of the input-consuming edge provides a logical high and the input token provided as output from the input buffer satisfies the input-consumption condition of the input-consuming edge, provide a logical high to circuitry for the destination vertex of the input-consuming edge on a next clock tick, the input buffer advancing to a next input token and providing the next input token as output from the input buffer on said next clock tick. The implemented circuitry for each non-input-consuming edge comprises a coupling between circuitry for the source vertex of the non-input-consuming edge and circuitry for the destination vertex of the non-input-consuming edge.

The implemented circuitry for each embedded-network-calling edge further comprises logic to, in response to one or more calling-edge conditions associated with that edge all being satisfied, provide a logical high to the implemented circuitry for the destination vertex of that edge and store a value in a memory associated with that embedded-network-calling edge, the value indicative of that embedded-network-calling edge having been transitioned, the one or more calling-edge conditions associated with that edge including a requirement that the implemented circuitry for the source vertex of that edge provides a logical high.

The implemented circuitry for each embedded-network-returning edge further comprises logic to, in response to a plurality of returning-edge conditions associated with that edge all being satisfied, provide a logical high to the implemented circuitry for the destination vertex of that edge, the plurality of returning-edge conditions associated with that edge including: a requirement that the implemented circuitry for the source vertex of that edge provides a logical high and a requirement that the memory associated with the corresponding embedded-network-calling edge for that embedded-network-returning edge has stored thereon the value indicative of that corresponding embedded-network-calling edge having been transitioned.

In some examples, the one or more calling-edge conditions and the plurality of returning-edge conditions comprise only those calling-edge and returning-edge conditions listed above.

Alternatively, the one or more calling-edge conditions associated with at least one embedded network-calling edge may further include a requirement that the input token provided as output from the input buffer satisfies an input-consumption condition associated with a next input-consuming edge downstream of the destination vertex of that embedded-network-calling edge. In some examples, all embedded-network-calling edges include such a requirement.

Alternatively or additionally, the plurality of returning-edge conditions associated with at least one embedded-network-returning edge may further include a requirement that the input token provided as output from the input buffer satisfies an input-consumption condition associated with a next input-consuming edge downstream of the destination vertex of that embedded-network-returning edge. In some examples, all embedded-network-returning edges include such a requirement.

Alternatively or additionally, each non-input-consuming edge in the transition network may represent an epsilon transition.

Alternatively or additionally, an embedded network may be embedded in multiple locations within a network of the transition network using separate embedded-network-calling edges connected to the start vertex of the embedded network from different vertices and using separate corresponding embedded-network-returning edges connected from the end vertex of the embedded network to different vertices.

Alternatively or additionally, the an embedded network is optionally embedded within more than one network of the plurality of networks.

Alternatively or additionally, the memory associated with each embedded-network-calling edge may comprise a register to store the value indicative of that embedded-network-calling edge having been transitioned.

Alternatively or additionally, each embedded-network-calling edge may have a separate dedicated associated memory.

Alternatively or additionally, for at least one embedded-network-calling edge, the memory associated with that embedded-network-calling edge may be configured to store a first value, such as 1, as the value indicative of that embedded-network-calling edge having been transitioned.

Alternatively or additionally, for at least one embedded-network-calling edge, the memory associated with that embedded-network-calling edge may be configured to store a value indicative of the corresponding embedded-network-returning edge for that embedded-network-calling edge as the value indicative of that embedded-network-calling edge having been transitioned.

Alternatively or additionally, the implemented circuitry for each embedded-network-calling edge may be further configured to overwrite any previous value stored in the memory associated with that that embedded-network-calling edge when storing the value indicative of that embedded-network-calling edge having been transitioned.

Alternatively or additionally, the implemented circuitry for each embedded-network-calling edge may be further configured to, in response to one or more calling-edge conditions associated with that edge all being satisfied, clear any previous values stored in any memory associated with any other embedded-network-calling edge that has the same destination vertex. Optionally, clearing any previous values stored in any memory associated with any other embedded-network-calling edge that has the same destination vertex may comprise overwriting said previous values by storing a second value, such as 0.

Alternatively or additionally, at least one vertex of a network of the transition network may have a plurality of incoming directed edges and the implemented circuitry for the vertex comprises a logical OR gate, wherein the implemented circuitry for each of the plurality of incoming directed edges of the vertex is electrically connected as an input to the logical OR gate.

Alternatively or additionally, generating the hardware description comprises implementing a lexer in the hardware description, wherein the implemented lexer is configured to lex input data into a sequence of input tokens to be provided to the input buffer.

Alternatively or additionally, providing the digitally stored graph representing the transition network comprises processing a digitally stored graph representing an initial transition network by performing one or more of the following operations: i) ensuring that edges connected to or from an embedded network are non-input-consuming edges, and ii) inlining an embedded network. Ensuring that edges connected to or from an embedded network are non-input-consuming edges may optionally comprise, for each embedded network of the initial transition network, if an edge connected to or from the embedded network is an input-consuming edge, inserting a new vertex and a new non-input consuming edge between the input-consuming edge and the embedded network.

Alternatively or additionally, the grammar may define a data format that comprises: i) a JSON schema, or ii) an XML Schema Definition, XSD, or iii) an ASN.1 schema.

Alternatively or additionally, the hardware description for configuring the digital electronic circuit may be generated in a hardware description language such as Verilog or VHDL (Very High-Speed Integrated Circuit Hardware Description Language).

Alternatively or additionally, the transition network may be a recursive transition network, RTN or an augmented transition network, ATN. In the case of an RTN, providing the digitally stored graph representing the RTN may comprise constructing the RTN based on an augmented transition network, ATN, that corresponds to the rules of the grammar. Optionally the ATN may comprise one or more actions and/or conditions. Optionally, the RTN may be constructed by removing the one or more actions and/or conditions from the ATN.

In accordance with a further aspect of this disclosure, any of the above-described methods may be performed using an ATN instead of an RTN. Such a method may comprise: providing a digitally stored graph representing an RTN or ATN based on the rules of the grammar and generating the hardware description in a hardware description language or as a netlist based on the RTN or ATN by performing the steps set out above, wherein the ATN has the same specified features as the RTN set out above, and wherein the generation of the hardware description based on the ATN follows the same steps set out above in respect of the RTN.

In accordance with a further aspect of this disclosure, there is provided a computer-implemented method of generating a hardware description for configuring a digital electronic circuit to parse input data against an LL(*) grammar that defines a data format, the input data comprising a sequence of input tokens, the method comprising: providing a digitally stored graph representing a transition network based on the rules of the LL(*) grammar, and generating the hardware description in a hardware description language or as a netlist based on the transition network. The LL(*) grammar is not LL(1). The transition network comprises a plurality of vertices and a plurality of directed edges connected between vertices of the network, the plurality of vertices including a start vertex and an end vertex, each directed edge connected between a respective source vertex and destination vertex of the network. The plurality of directed edges of the transition network comprises a plurality of input-consuming edges and a plurality of non-input-consuming edges. Each input-consuming edge represents a transition between its source vertex and its destination vertex conditional on a current input token of the input data matching an input-consumption condition associated with the input-consuming edge, wherein parsing of the input data advances to a next input token of the input data with the transition. Each non-input-consuming edge represents a transition between its source vertex and its destination vertex without the parsing of the input data advancing to a next input token of the input data with the transition. Generating the hardware description comprises implementing an input buffer in the hardware description to store a sequence of input tokens of the input data, the input buffer configured to provide an input token of the sequence of input tokens as output from the input buffer, wherein the input buffer is further configured to sequentially advance through the sequence of input tokens by, on a clock tick, providing a next input token as output from the input buffer. Generating the hardware description comprises further implementing circuitry in the hardware description for the edges and vertices of the transition network. The implemented circuitry for each vertex is electrically connected to the implemented circuitry for each edge that is connected to the vertex in the transition network, the implemented circuitry for each vertex configured to output a logical high to circuitry for all outgoing directed edges of that vertex if circuitry for an incoming directed edge of that vertex provides a logical high. The implemented circuitry for each input-consuming edge comprises a register with associated logic configured to compare an input token provided as output from the input buffer with the input-consumption condition associated with that input-consuming edge, the register with associated logic configured to, if the implemented circuitry for the source vertex of the input-consuming edge provides a logical high and the input token provided as output from the input buffer satisfies the input-consumption condition of the input-consuming edge, provide a logical high to circuitry for the destination vertex of the input-consuming edge on a next clock tick, the input buffer advancing to a next input token and providing the next input token as output from the input buffer on said next clock tick. The implemented circuitry for each non-input-consuming edge comprises a coupling between circuitry for the source vertex of the non-input-consuming edge and circuitry for the destination vertex of the non-input-consuming edge.

Optionally, the transition network does not include any embedded networks.

In accordance with a further aspect of this disclosure, there is provided a computer-implemented method of generating a hardware description for configuring a digital electronic circuit to parse input data against an LL(*) grammar that defines a data format, the input data comprising a sequence of input tokens, the method comprising: providing a digitally stored graph representing a transition network based on the rules of the LL(*) grammar; and generating the hardware description in a hardware description language or as a netlist based on the transition network. The LL(*) grammar is not LL(1).

Optionally, either the transition network does not include any embedded networks, or the transition network is such that for all input data that conforms to the LL(*) grammar, during parsing of the input data against the grammar, after a first embedded-network-calling edge to any embedded network within the transition network is transitioned, no embedded-network-calling edges to that embedded network are subsequently transitioned until either the embedded-network-returning edge corresponding to the first embedded-network-calling edge has been transitioned or the parse reaches a state where no input-consuming edge within that embedded network can be transitioned for the next input token.

In accordance with a further aspect of this disclosure, there is provided a method of configuring a digital electronic circuit to parse input data, the method comprising: generating a hardware description in accordance with any of the above-described methods; and configuring a digital electronic circuit based on the hardware description. Optionally, the digital electronic circuit may be an application-specific integrated circuit, ASIC, or a field-programmable gate array, FPGA. Configuring an ASIC in accordance with the hardware description may comprise manufacturing an ASIC in accordance with the hardware description, wherein the ASIC is capable of performing the parsing operations described herein. Configuring an FPGA in accordance with the hardware description may comprise configuring an FPGA such that the FPGA is capable of performing the parsing operations described herein.

In accordance with a further aspect of this disclosure, there is provided a digital electronic circuit such as an FPGA or ASIC configured according to any of the above-described methods.

The techniques of this disclosure address a problem with existing approaches to parsing data against a grammar that defines a data format in order to validate that data before subsequent processing, with the aim of reducing the risk of malicious code causing arbitrary code execution on the devices performing the subsequent processing. Specifically, an existing approach may generate source code for software to parse data, wherein the software is run on a general-purpose computer, i.e. a Turing-complete machine. This means that the parsing software run on a general-purpose computer is itself susceptible to malicious code in the data, and may potentially be caused to execute arbitrary code including code to cause the parsing to software to falsely parse data that includes malicious code, allowing such data to be subsequently processed by downstream computers. This represents a potential security risk.

The techniques of this disclosure provide a hardware description for configuring a digital electronic circuit to parse input data comprising a sequence of input tokens against an LL(*) grammar that defines a data format. Unlike a general-purpose computer, the digital electronic circuit may be a non-Turing-complete machine. The digital electronic circuit may be an application-specific integrated circuit (ASIC), where the functionality of the circuit is fixed at manufacture. The digital electronic circuit may be a field-programmable gate array, where the functionality of the circuit may be configurable but not by data processed by the FPGA. Typically, the FPGA is configurable via an entirely separate channel to any input/output channel of the FPGA that is used to input or output data to be processed. The use of a digital electronic circuit to perform parsing of input data is therefore potentially more secure than use of parsing software on a general-purpose computer. However, a disadvantage to the use of a digital electronic circuit in such a way in that it might be relatively inflexible. It may be difficult to modify the digital electronic circuit to parse data according to a new data format, such as an arbitrary or custom data format. By contrast, for parsing software run on a general-purpose computer, a tool such as ANTLR can be used to generate new parsing software for any arbitrary data format. This software can be run on the same general-purpose computer. Essentially, the design process for hardware such as a digital electronic circuit is more intensive or laborious than the design process for a software parser, particularly using a tool such as ANTLR.

The techniques of this disclosure include a method of generating a hardware description for configuring a digital electronic circuit, such as an application-specific integrated circuit (ASIC) or a field-programmable gate array (FPGA). The hardware description configures the digital electronic circuit to parse input data comprising a sequence of input tokens against an LL(*) grammar. This is achieved by implementing a recursive transition network (RTN) or an augmented transition network (ATN) representing the grammar within the digital electronic circuit. When the LL(*) grammar defines a data format, such as a JSON schema, XML Schema Definition (XSD), or ASN.1 schema, a document can be validated against the data format by the configured digital electronic circuit processing the document as the input data. The method may be computer-implemented. The method may therefore be performed by a computer to automatically generate a hardware description and optionally also automatically configure a digital electronic circuit based on the hardware description for an arbitrary data format defined by a context-free grammar. This approach may therefore address a security risk in software parsing without compromising flexibility for parsing against an arbitrary context-free grammar that defines a data format.

Furthermore, known methods of parsing against an LL(*) grammar involve buffering the upcoming sequence of multiple look-ahead input tokens at ambiguous points and iteratively comparing this buffered sequence of tokens against a set of regular expressions for all grammar rules which may be applied at that point, until resolution of the correct rule to take in the grammar is complete. Such techniques have a number of drawbacks:
- Large buffers may be required to hold the necessary look-ahead input token sequences.
- The regular expression state space may be large and computationally expensive to explore.
- Such comparison of the set of regular expressions against the buffered look-ahead sequence needs to be completed before the parse can continue, which can result in having to pause the processing of the input data sequence until the ambiguity in which rule to take has been resolved.

The techniques of this disclosure provide a hardware description for configuring a digital electronic circuit to parse input data comprising a sequence of input tokens against an LL(*) grammar. Unlike known LL(*) parsers, at ambiguous points in the parse the digital electronic circuit can continue to process the stream of input tokens without any pause or look-ahead. When there is ambiguity in the grammar, the digital electronic circuit in effect explores all parsing possibilities in parallel, with one logical high signal propagating through the digital electronic circuit for each possibility. Thus the techniques described herein provide a hardware implemented LL(*) parser that dispenses with the need for look-ahead token buffering and corresponding regular expression processing.

### BRIEF DESCRIPTION OF DRAWINGS

Embodiments will now be described in relation to the accompanying drawings, in which:
Figure 1 shows a standard RTN representation for an example grammar;
Figure 2 shows a modified version of the RTN representation of Figure 1;
Figure 3 shows a schematic logical diagram of a digital electronic circuit created according to a hardware description generated based on the RTN of Figure 2;
Figure 4 shows a version of the RTN representation of Figure 2 modified by inlining;
Figure 5 shows a schematic logical diagram of a digital electronic circuit created according to a hardware description generated based on the RTN of Figure 4;
Figure 6 shows a schematic logical diagram of a digital electronic circuit created according to a hardware description generated based on the RTN of Figure 4.

### DETAILED DESCRIPTION

The techniques of this disclosure include a method of generating a hardware description for configuring a digital electronic circuit, such as an application-specific integrated circuit (ASIC) or a field-programmable gate array (FPGA). The hardware description configures the digital electronic circuit to parse input data comprising a sequence of input tokens against an LL(*) grammar. This is achieved by implementing a recursive transition network (RTN) or an augmented transition network (ATN) representing the grammar within the digital electronic circuit. When the grammar defining a data format, such as a JSON schema, XML Schema Definition (XSD), or ASN.1 schema, a document can be validated against the data format by the configured digital electronic circuit processing the document as the input data. The method may be computer-implemented. The method may therefore be performed by a computer to automatically generate a hardware description and optionally also automatically configure a digital electronic circuit based on the hardware description for an arbitrary data format defined by an LL(*) grammar.

By way of introduction, an example based on an LL(1) grammar will be described initially. Discussion of techniques for LL(*) grammars will then follow..

### Hardware Implementation of RTN with Embedded Networks

A method according to the techniques of this disclosure is presented for the following simple grammar in Table 1:

**TABLE 1**

| |
|---|
| content: START value EOF ; |
| value: DIGIT+ \| array; |
| array: OPEN_BRACKET value (COMMA value)* CLOSE_BRACKET ; |

This grammar is an LL(1) grammar. It has been expressed above using ANTLR G4 notation. ANTLR G4 notation is used by version 4 of the ANTLR (Another Tool for Language Recognition) software parser generator tool. Derivation of a grammar for a particular data format, such as a particular JSON schema, may be done manually or automatically/programmatically according to established techniques in this technical field. The resulting grammar may be expressed digitally using ANTLR G4 notation or using other digital grammar notations. For example, the grammar may be expressed using an extended Backus-Naur form (EBNF) notation. Each of "content", "value" and "array" in TABLE 1, i.e. the elements that begin each line of Table 1, are referred to as rules within the grammar

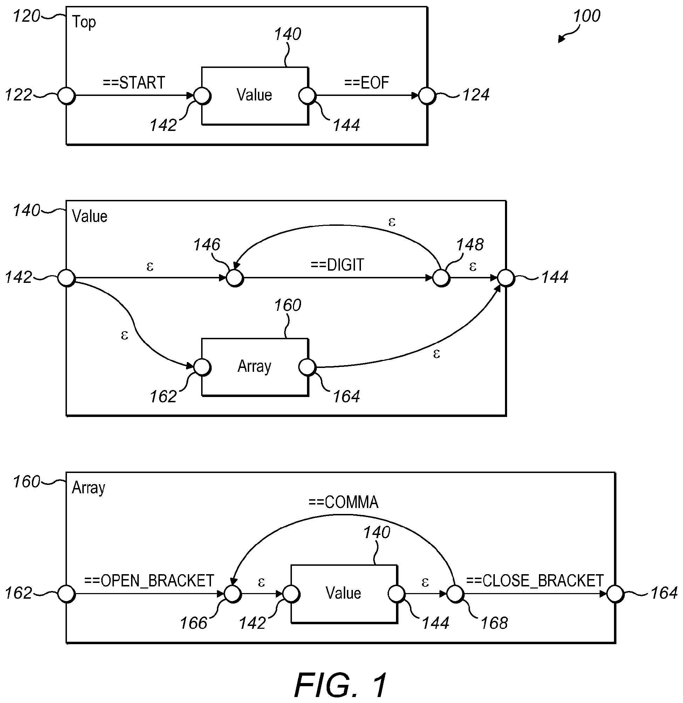

A Recursive Transition Network (RTN) may be generated for an LL(1) grammar according to established techniques in this technical field. Figure 1 shows an RTN representation 100 for the example grammar of Table 1. The RTN 100 includes three networks: i) a first network 120 (labelled 'Top' in Figure 1, corresponding to the rule "content"), ii) a first embedded network 140 (labelled 'Value' in Figure 1, corresponding to the rule "value"), and iii) a second embedded network 160 (labelled 'Array' in Figure 1, corresponding to the rule "array"). In the RTN 100 of Figure 1, the first embedded network 140 is embedded within both the first network 120 and the second embedded network 160, and the second embedded network 160 is embedded within the first embedded network 140.

Within the technical field of transition networks and RTNs in particular, a transition to an embedded network from a network in which it is embedded may be referred to as a 'call' to the embedded network. Moving back from the embedded network to the network in which it is embedded may be referred to as a 'return'. A return from an embedded network should return to the network from which the corresponding call to that embedded network was made.

For example, in the RTN 100 of Figure 1, if a first call is made from the first network 120 to the first embedded network 140, and then a second call is subsequently made from the first embedded network 140 to the second embedded network 160, and then a third call is subsequently made from the second embedded network 160 to the first embedded network 140, a return corresponding to the third call must be made from the first embedded network 140 to the second embedded network 160, and then a return corresponding to the second call must subsequently be made from the second embedded network 160 to the first embedded network 140, and then a return corresponding to the first call must subsequently be made from the first embedded network 140 to the first network 120. In other words, the steps of calling and returning within an RTN should follow a correct sequence for proper operation of the RTN. The techniques of this disclosure concern the generation of a hardware description for a digital electronic circuit that implements a transition network such as an RTN.

In general, the structure of the networks of the RTN is defined by the specific grammar of the RTN. Each embedded network may be embedded within itself (one or more times) and/or at least one other network of the RTN. The embedding of the networks can lead to a recursive property in the RTN. There are two types of recursion. Firstly, a network may be recursively embedded within itself, such that it may call itself any number of times. This can be described as direct recursion. Secondly, a first network may be embedded in another network which is itself embedded in the first network. In such a case, the first network is indirectly recursively embedded within itself, resulting in recursion. This can be described as indirect recursion.

Looking at Figure 1 in more detail, the networks 120,140,160 each include a number of vertices, shown through the circular symbols in Figure 1, including a respective start vertex 122,142,162 and a respective end vertex 124,144,164 for each network. The vertices of each network are connected via a number of directed edges, with each directed edge connected between a respective source vertex and respective destination vertex in the network including that directed edge. Each directed edge is either an input-consuming directed edge or a non-input-consuming directed edge. An input-consuming edge allows a transition from its source vertex to its end vertex if the input (e.g. current input token) matches an input-consumption condition of that edge, after which that input is 'consumed', and the input proceeds to a next value in an input sequence (e.g. next input token). Figure 1 illustrates some example input-consuming edges, discussed below. A non-input-consuming edge allows transition without 'consuming' an input. In Figure 1, the non-input-consuming edges are epsilon transitions, which have no input-consumption condition attached and for which the transition can be made freely. These epsilon transitions are shown with 'ε' in Figure 1. In some examples, a non-input-consuming edge might not be an epsilon transition. For example, a non-input-consuming edge might have an associated edge condition that might restrict transition unless the edge condition is satisfied.

For example, in Figure 1 the first network 120 ('Top') includes a start vertex 122, which is connected by an input-consuming edge 1 to the start vertex 142 of the first embedded network 140 ('Value'). The input-consuming edge 1 has an input-consumption condition '==START'. If the input (e.g. current input token) satisfies this input-consumption condition, i.e. is equal to 'START', then the transition is permitted and that input is 'consumed'. Traversal through the RTN proceeds to that edge's destination vertex, which is the start vertex 142 of the first embedded network 140. The first network 120 also includes an input-consuming edge 6 with the input-consumption condition "==EOF" connected between the end vertex 144 of the first embedded network 140 and the end vertex 124 of the first network 120. If the input (e.g. current input token) satisfies this input-consumption condition, i.e. is equal to 'EOF', then the transition is permitted and that input is 'consumed'. Traversal through the RTN proceeds to that edge's destination vertex, which is the end vertex 124 of the first network 120.

The first embedded network 140 ('Value') includes a start vertex 142, which is connected by a non-input-consuming edge 4 to the start vertex 162 of the second embedded network 160 ('Array'). The first embedded network 140 also includes a non-input-consuming edge 12 connected between the end vertex 164 of the second embedded network 160 and the end vertex 144 of the first embedded network 140. Further, the first embedded network 140 includes a non-input-consuming edge 3 connected between the start vertex 142 and a first intermediate vertex 146. An input-consuming edge 13 with the input-consumption condition "==DIGIT" connects the first intermediate vertex 146 to a second intermediate vertex 148. If the input (e.g. current input token) satisfies this input-consumption condition, then the transition is permitted and that input 'digit' is 'consumed'. Traversal through the RTN proceeds to that edge's destination vertex, which is the second intermediate vertex 148. The second intermediate vertex 148 is connected to the end vertex 144 of the first embedded network 140 via a non-input-consuming edge 15, and is also connected back to the first intermediate vertex 146 via a non-input-consuming edge 14.

The second embedded network 160 similarly includes first and second intermediate vertices 166,168, and a number of input-consuming edges and non-input-consuming edges as shown in Figure 1. The second embedded network 160 includes a start vertex 162 and an end vertex 164. The start vertex 162 is connected via an input-consuming edge 7 to a first intermediate vertex 166, wherein the input-consuming edge has the attached input-consumption condition of '==OPEN_BRACKET'. In addition to the input-consuming edge 7, the first intermediate vertex 166 has another inbound input-consuming edge 10 from a second intermediate vertex 168, wherein the input-consuming edge 10 has the attached input-consumption condition of '==COMMA'. The first intermediate vertex 166 has an outbound non-input-consuming edge 8 to vertex 142 of the first embedded network 140 (i.e. the first embedded network's start vertex). The second intermediate vertex 168 has an inbound non-input-consuming edge 9 from vertex 144 of the first embedded network (i.e. the first embedded network's end vertex). The second embedded network 160 includes an input-consuming edge 11 with the attached input-consumption condition '==CLOSE_BRACKET" that is outbound from the second intermediate vertex 168 and connects to the end vertex 164 of the second embedded network 160.

An RTN, such as the RTN 100 of Figure 1, represents the rules of the relevant grammar graphically. It can be determined whether some input data formed from a stream of input tokens conforms to the grammar by parsing the input data. In the graphical RTN representation, each input-consuming edge represents a transition between its source vertex and its destination vertex conditional on the current input token of the input data matching the input-consumption condition associated with that input-consuming edge. For example, the transition from the start vertex 122 of the first network 120 ('Top') to the start vertex 142 of the first embedded network 140 is conditional on the current input token of the input data being "START". Parsing of the input data advances to the next input token of the input data when the transition occurs.

Further, in the graphical RTN representation, each non-input-consuming edge represents an epsilon transition, which is a transition that is not conditional on the current input token of the input data and does not cause the parsing to advance to the next input token of the input data when the transition occurs.

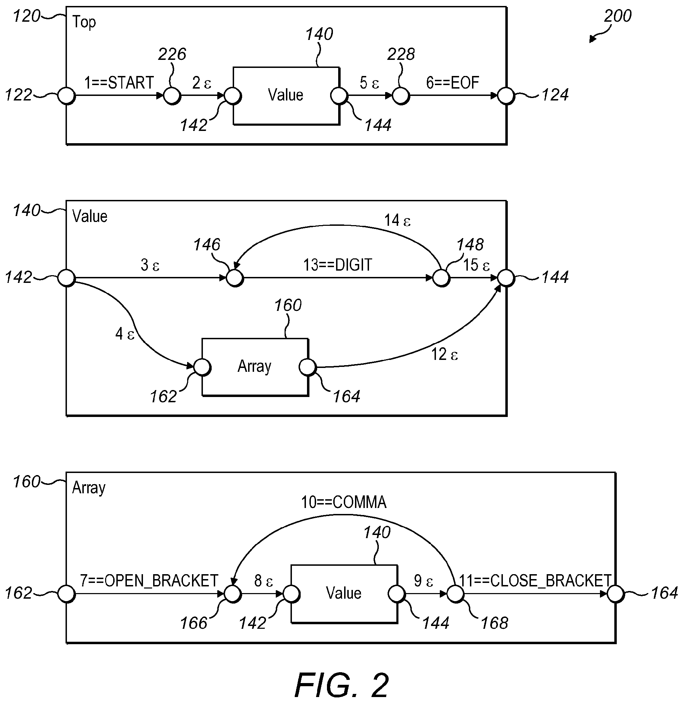

In an example in accordance with the techniques of this disclosure, a modification can optionally be made to an initial RTN. This modification may be an optional preliminary step in a method of generating a hardware description for configuring a digital electronic circuit in accordance with the techniques of this disclosure. This modification involves processing a digitally stored version of the RTN 100. Various different formats may be used to digitally store the RTN. For example, a linked list of vertices and directed edges may be used to digitally store an RTN. The modification involves, if an edge connected to or from an embedded network is an input-consuming edge, inserting a new vertex and a new non-input-consuming edge between the input-consuming edge and the embedded network, such that all incoming and outgoing directed edges from the embedded networks are epsilon transitions. The step may include determining, for an edge connected to or from an embedded network, whether the edge is an input-consuming edge. If the edge is an input-consuming edge directed to the embedded network (i.e. the destination vertex of the input-consuming edge is a vertex of the embedded network), the RTN may be modified such that then input-consuming edge has the new inserted vertex as its destination vertex, and a new inserted edge is an epsilon transition between the new inserted vertex and the embedded network. If the edge is an input-consuming edge outgoing from an embedded network (i.e. the source vertex of the input-consuming edge is a vertex of the embedded network), the RTN may be modified such that then input-consuming edge has the new inserted vertex as its source vertex, and a new inserted edge is an epsilon transition between the embedded network and the new inserted vertex. The result of such a modification to the RTN 100 is shown in Figure 2.

The RTN 200 of Figure 2 is identical to the RTN 100 of Figure 1, except that the first network 120 ('Top') in Figure 2 includes an intermediate vertex 226 as the destination vertex of the input-consuming edge with the input-consumption condition "==START", the intermediate vertex 226 itself being connected by a non-input-consuming edge to the start vertex 142 of the first embedded network 140. Additionally an intermediate vertex 228 is included as the destination vertex of a non-input-consuming edge from the end vertex 144 of the first embedded network 140, the intermediate vertex 228 being the source vertex for the input-consuming edge with the input-consumption condition "==EOF" connected to the end vertex 124 of the first network 120. The RTN 200 represents the same grammar as the RTN prior to this modification. The addition of these new vertices and edges does not change the grammar represented by the RTN but may offer advantages in generating a digital electronic circuit to parse data according to the grammar.

Such a modification can be made generally for any RTN, such that all incoming and outgoing directed edges from the embedded networks are non-input-consuming edges, i.e. epsilon transitions in particular. Further, for some RTNs this will already be the case, such that no modification is needed. In either case, an RTN having only epsilon transitions into and out of embedded networks is used to form the digitally stored graph from which the hardware description is generated in the methods described herein, as outlined in more detail below.

In the RTN of Figure 2, each directed edge, both input-consuming and non-input-consuming has also been given numerical label. This is to aid understanding in the following description.

In an RTN having only epsilon transitions into and out of embedded networks, such as the RTN 200 of Figure 2, for each network within which an embedded network is embedded, the non-input-consuming edge in that network that is connected to a start vertex of the embedded network will be referred to as an embedded-network-calling edge (or simply a calling edge). Similarly, the non-input-consuming edge in that network which is connected from the end vertex of the embedded network will be referred to as a corresponding embedded-network-returning edge (or simply a returning edge). In other words, for each embedded-network-calling edge and corresponding embedded-network-returning edge: the source vertex of the embedded-network-calling edge and destination vertex of the embedded-network-returning edge are vertices of the network within which the embedded network is embedded, the destination vertex of the embedded-network-calling edge is the start vertex of the embedded network, and the source vertex of the embedded-network-returning edge is the end vertex of the embedded network.

For example, the non-input-consuming edge (epsilon transition) labelled 2 in the first network 120 in Figure 2 is a first-embedded-network-calling edge, and the non-input-consuming edge labelled 5 in Figure 2 is a corresponding first-embedded-network-returning edge. Similarly, the non-input-consuming edge labelled 8 in Figure 2 in the second embedded network 160 is a first embedded-network-calling edge, and the non-input-consuming edge labelled 9 is a corresponding first embedded-network-returning edge.

Further, the non-input-consuming edge labelled 4 in the first embedded network 140 in Figure 2 is a second embedded-network-calling edge, and the non-input-consuming edge labelled 12 in the first embedded network 140 in Figure 2 is a corresponding second embedded-network-returning edge.

Using the above-described terminology, a method of generating a hardware description for configuring a digital electronic circuit to parse input data against the example grammar above will now be described, the method in accordance with the techniques of this disclosure.

The method begins with the digitally stored RTN 200 of Figure 2, i.e. having embedded-network-calling and embedded-network-returning edges that are epsilon transitions. The method enables the implementation of this RTN as a digital electronic circuit by generating a hardware description for the digital electronic circuit.

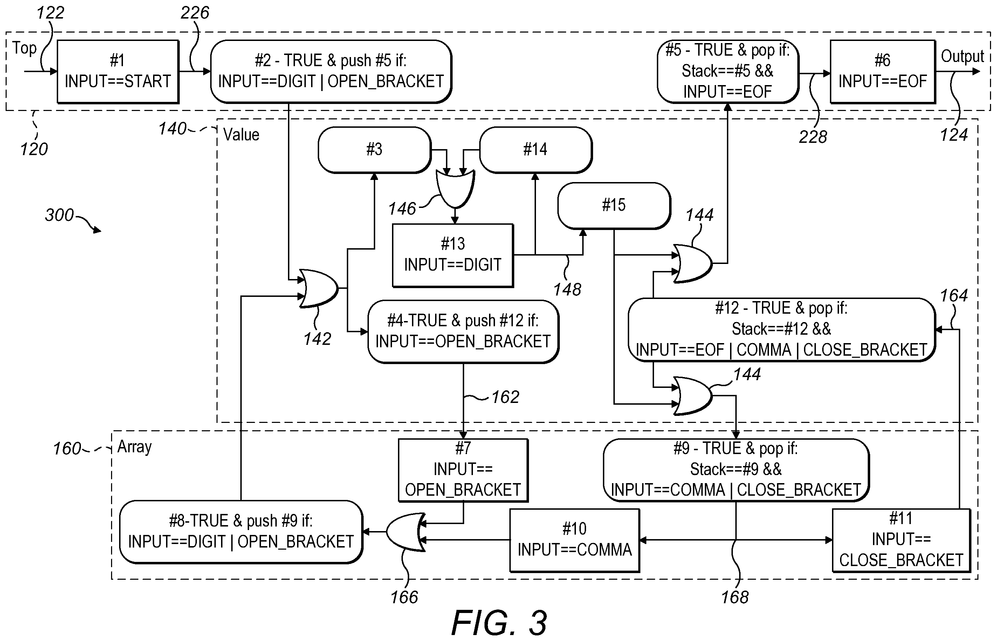

Figure 3 shows a schematic logical diagram of a digital electronic circuit 300 created according to the hardware description generated based on the RTN 200.

In the method, instructions for an input buffer in the digital circuit (not shown in Figure 3) are included in the hardware description. In the digital electronic circuit, the input buffer stores the sequence of input tokens of the input data, and sequentially outputs each input token in sequence, the input buffer providing a current input token as output until a next clock tick.

Instructions for circuitry corresponding to each of the edges and each of the vertices of the RTN 200 are also included in the hardware description. The circuitry for each directed edge in the RTN 200, both input-consuming and non-input-consuming, is shown in Figure 3 as a block having the same numerical label as the numerical label of the corresponding edge in Figure 2. The circuitry for each vertex is shown in Figure 3 as a connection between block, using the same reference numeral as used for the corresponding vertex in Figure 2. The circuitry conforms to the following rules based on the RTN:
Firstly, the circuitry for each vertex is electrically connected to the corresponding circuitry for each edge that is connected to that vertex in the RTN 200. Further, the circuitry for each vertex outputs a logical high (e.g. a voltage representative of a logical high) to circuitry for all outgoing directed edges of that vertex (i.e. all edges for which that vertex is a source vertex) if circuitry for any incoming directed edge of that vertex (i.e. any edge for which that vertex is a destination vertex) provides a logical high. In other words, the circuitry for that vertex conveys a logical high from any incoming directed edge to all outgoing directed edges of that vertex.

For example, in the case of the intermediate vertex 226 in the first network 120 ('Top') of RTN 200 between the input-consuming edge labelled 1 and the non-input-consuming edge labelled 2, the circuitry for that vertex is an electrical connection that outputs a logical high to the circuitry for the non-input-consuming edge 2 when a logical high is received from circuitry for the input-consuming edge 1. This electrical connection may simply be a wire or plain conductor or the like in the digital electronic circuit. The hardware description would therefore include instructions for a plain conductor connection between the circuitry for input-consuming edge 1 and the circuitry for non-input-consuming edge 2.

In the case where the vertex has multiple outgoing directed edges, such as the intermediate vertex 148 in the first embedded network 140 ('Value') of RTN 200, the circuitry for the vertex outputs a logical high to the circuitry for all outgoing edges when the circuitry for the vertex receives a logical high. For example, the hardware description could include instructions for a plain conductor connection between the circuitry for input-consuming edge 13 and the circuitry for both non-input-consuming edge 14 and non-input-consuming edge 15.

Further, in the case where a vertex has multiple incoming directed edges, such as the intermediate vertex 146 in the first embedded network 140 ('Value') of RTN 200, the circuitry for the vertex outputs a logical high to the circuitry for all outgoing edges when it receives a logical high voltage signal from any of the circuitry for the incoming edges. This can be achieved using a logical OR gate in the vertex circuitry. For example, the hardware description could include for intermediate vertex 146 instructions for an OR gate having its input terminals connected to the circuitry for the non-input-consuming edges 3 and 14, and its output terminal connected to the circuitry for the input-consuming edge 13. In this way, the circuitry for input-consuming edge 13 receives a logical high whenever the circuitry for either of non-input-consuming edges 3 or 14 provides a logical high.

For vertices with multiple incoming edges that also have multiple outgoing edges, the output terminal of the OR gate is connected to the circuitry for each outgoing edges to output a logical high voltage signal to the circuitry for all outgoing edges when the circuitry for the vertex receives a logical high.

In some examples, a vertex with multiple incoming edges and multiple outgoing edges can be implemented using multiple OR gates, wherein circuitry for only some of the outgoing edges is connected to any one of the multiple OR gates.

In the RTN 200 shown in Figure 2, end vertex 144 has both multiple incoming directed edges and multiple outgoing directed edges. In the digital electronic circuit shown in Figure 3, the circuitry for end vertex 144 is shown separated into two separate OR gates, with a respective OR gate for each of the outgoing edges of end vertex 144. Each OR gate outputs a logical high to the circuitry for one of the outgoing directed edges (i.e. non-input-consuming edges 5 and 9). However, these two OR gates could instead be combined as a single OR gate having two outputs in some embodiments, as mentioned above. These two configurations are equivalent. Separating the vertex circuitry for a vertex with multiple outgoing edges in this way may be advantageous for routing purposes, whether in the hardware description or in a digital electronic circuit configured according to the hardware description.

Thus a vertex in the RTN 200 is included in the hardware description as an instruction to implement a logical OR for all of the incoming edges of that vertex, with the logical OR for a single incoming edge being a simple wire or plain conductor in some examples because the logical OR of a single input is the same as the input.

The circuitry for each input-consuming edge (shown as rectangular blocks in Figure 3) receives the input token of the input data presently output by the input buffer. The circuitry for each input-consuming edge includes logical circuitry that compares this current input token with the input-consumption condition associated with that input-consuming edge. The circuitry for each input-consuming edge also includes a register. If the current input token output by the buffer is found to match the input-consumption condition associated with that input-consuming edge by the logical circuitry, and if in addition the circuitry for the source vertex of that input-consuming edge is outputting a logical high voltage signal, the register in the circuitry for that input-consuming edge will, on the next clock tick, provides a logical high to the circuitry for the destination vertex of that input-consuming edge until the end of the next clock cycle.

For example, in the RTN 200 of Figure 2, the input-consumption condition associated with the input-consuming edge 1 is "==START", meaning the current input token of the input data must be equal to START. On a first clock tick, the buffer provides START as its output, wherein START is the first input token in the input data. This first input token is provided to the circuitry for each of the six input-consuming edges, i.e. input-consuming edges 1, 6, 7, 10, 11 and 13. Only input-consuming edge 1 has an input-consumption condition "==START" matching this first input token. Therefore the register in the circuitry for input-consuming edge 1 will output a logical high (if a logical high is also provided as input to the register, which may be an initial signal to initiate the parsing process or may be hardwired). The register in the circuitry will output this logical high signal on the next clock tick, i.e. on a second clock tick, and will continue to output this logical high signal for the entire clock cycle

(i.e. until a third clock tick). Also on the second clock tick, the input buffer advances to output DIGIT as the second input token in the input data. The register in the circuitry for input-consuming edge 1 will stop outputting a logical high at the next clock tick (third clock tick) because the current input token is DIGIT rather than START and so this edge's input-consumption condition is no longer satisfied. Only input-consuming edge 13 has an input-consumption condition "==DIGIT" matching this second input token. Because of this match, the register in the circuitry for input-consuming edge 13 would output a logical high at the next clock tick (third clock tick), provided that the circuitry for input-consuming edge 13 also receives a logical high from the circuitry of its source vertex (i.e. it receives a logical high signal from the output of the OR gate in the circuitry for intermediate vertex 146), which it does if the preceding input token was START.

The circuitry for each non-input-consuming edge (shown as blocks with rounded corners in Figure 3) includes a coupling between circuitry for the source vertex of that non-input-consuming edge and circuitry for the destination vertex of the non-input-consuming edge.

In the case of non-input-consuming edges that are not embedded-network-calling or embedded-network-returning edges, such as non-input-consuming edges 3, 14, 15 in Figure 2, this coupling may simply be a wire or other conductor or the like. If a logical high is received from the circuitry for the source vertex, the logical high is provided to the circuitry for the destination vertex.

In the case of embedded-network-calling edges and embedded-network-returning edges (also referred to as 'calling edges' and 'returning edges' for brevity), i.e. non-input-consuming edges 2, 4, 5, 8, 9, 12, the coupling includes combinational (non-registered) logic configured to perform a number of additional acts, as outlined below.

Instructions for a memory in the digital circuit (not shown in Figure 3) are included in the hardware description. In the digital electronic circuit, the memory is configured to store a value and provide the stored value as output from the memory. In this example, the memory is a stack. The output from the memory is the value at the top of the stack.

For the calling edges, a call from a network to an embedded network (e.g. from 'Top' to 'Value') requires pushing to the top of the stack the identity of the returning edge that will be followed on return from that embedded network (referred to as the "corresponding" returning edge for each specific calling edge). Further, there is performed a check that the current input token provided by the buffer will be consumed by one of the immediately subsequent input-consuming edges that follows the calling edge in the RTN, i.e. is downstream from the destination vertex of the calling edge (the start vertex of the embedded network). By 'consumed', it is meant that the input-consumption condition of that input-consuming edge will match the current input token and cause the input-consuming edge to provide a logical high when a logical high provided from the calling edge propagates through the circuit to that input-consuming edge. For example, in the RTN of Figure 2, the next input-consuming edge downstream from the calling edge labelled 2 is either input-consuming edge 13 or input-consuming edge 7. Similarly, the next input-consuming edge downstream of the calling edge labelled 4 is the input-consuming edge 7.

Therefore, the logic in the circuitry for each calling edge receives the input token of the input data that is currently provided by the input buffer. The logical circuitry of each calling edge is configured to compare this current input token with the input-consumption conditions associated with the next input-consuming edge/edges downstream of the destination vertex of that calling edge. If the input token matches an input-consumption condition of one of these next input-consuming edges for that calling edge, and additionally if the circuitry for the source vertex of that calling edge provides a logical high, then logical circuitry for that calling edge provides a logical high to the circuitry for the destination vertex of that calling edge, and also pushes to the top of the stack a value indicative of the corresponding returning edge for that calling edge. The corresponding returning edge represents the returning edge to be followed on exit from the embedded network when entered from the calling edge. By storing a value indicative of the corresponding returning edge, this information can be used to ensure that the embedded network is exited to a correct corresponding returning edge, which may be advantageous if the embedded network is callable from multiple locations within the RTN. By using a stack for this purpose, nested levels of embedded networks may be called and returned from in an appropriate sequence.

Using the calling edge labelled 2 in RTN 200 as an example, if the circuitry for the intermediate vertex 226 outputs a logical high to the circuitry for calling edge 2, and if the current output from the buffer is either DIGIT or OPEN_BRACKET, then the combinational logic in the circuitry for calling edge 2 outputs a logical high to the circuitry for the start vertex 142 of the first embedded network 140, and pushes to the stack a value indicative of the returning edge labelled 5 in Figure 2.

In some embodiments, each directed edge in the RTN may be given an identifier, such as the labelling numbers in Figure 2, and these identifiers may be used as the values indicative of the returning edges. The identifiers may optionally be unique such that no two edges in the RTN have the same identifier. Alternatively, in some examples only certain edges have an identifier, such as only those edges that are calling or returning edges have identifiers, or only those edges that are returning edges have identifiers. Some practical implementations may provide all edges with identifiers as a consequence of digitally storing a graph representing the RTN.

Similarly, for the returning edges, a return from an embedded network to the network in which it is embedded (e.g. from 'Value' to 'Top') requires a check that the value indicative of that returning edge is present at the top of the stack as the output of the memory. There is also performed a check that the current input token output by the buffer will be consumed by (match the input-consumption condition of) one of the immediately subsequent input-consuming edges that is downstream of the returning edge in the RTN. If these returning-edge conditions are met, the value indicative of that returning edge is popped from the top of the stack. In determining whether an input-consuming edge is immediately subsequent/downstream of a returning edge, any non-input-consuming edges that represent epsilon transitions between the returning edge and an input-consuming edge may be disregarded because a logical high may be considered to propagate unconditionally through the epsilon transitions.

Therefore the logic in the circuitry for each returning edge receives the input token of the input data currently provided as output by the input buffer. The logic compares this current input token with the input-consumption conditions associated with the next input-consuming edge/edges downstream of the destination vertex of the returning edge. If the input token matches an input-consumption condition of one of these next input-consuming edges, and additionally if the circuitry for the source vertex of that returning edge provides a logical high, and additionally if the value at the top of the stack is indicative of that returning edge, then the logical circuitry for the returning edge provides a logical high to the circuitry for the destination vertex of that returning edge and pops the value indicative of that returning edge from the stack. Thus each call to an embedded network from a calling edge pushes a value to the stack and each return from an embedded network from a returning edge pops a value from the stack. By checking the value at the top of the stack and confirming it to be indicative of the returning edge, nested embedded networks may be called and returned from in the appropriate sequence, even with direct or indirect recursion.

Using the returning edge labelled 5 in RTN 200 as an example, if the circuitry for the end vertex 144 of the first embedded network 140 outputs a logical high to the circuitry for calling edge 5, and if the present output from the buffer is EOF, and if the value at the top of the stack is indicative of returning edge 5, then the combinational logic in the circuitry for returning edge 5 outputs a logical high signal to the circuitry for the intermediate vertex 228.

As mentioned, Figure 3 shows the resulting digital electronic circuit configured according to the hardware description generated by applying all of the above rules to the RTN 200 of Figure 2. In other words, Figure 3 shows the RTN 200 of Figure 2 implemented in a digital electronic circuit. The hardware description specifies the logical arrangement of elements of the digital electronic circuit that implements the RTN.

A hardware description generated by a method in accordance with the techniques disclosed herein may be expressed in any suitable hardware description language (HDL), for example, using VHSIC Hardware Description Language (VHDL) or Verilog. This hardware description may be used to create a digital electronic circuit, such as by synthesizing a configuration for an FPGA device, or creating a layout for an ASIC (e.g. using electronic design automation software tools). In other embodiments, the hardware description may be generated directly in the form of a netlist, i.e. without generating a hardware description in a hardware description language as an intermediate representation of the digital electronic circuit. In some embodiments, generating a hardware description in a hardware description language or in the form of a netlist may comprise generating the hardware description using a hardware description language and a netlist in combination.

The hardware-implemented RTN in the digital electronic circuit of Figure 3 can be used to parse input data in the form of a stream of input tokens against the grammar associated with the RTN. An example parsing process will now be described based on Figure 3.

Firstly, the input data is stored in the input buffer, and the first input token in the input data is output from the buffer at the start of the parsing operation, i.e. on a first clock tick. The buffer then sequentially outputs, on each clock tick, each input token in the input data. The input token may be held as output from the input buffer for the duration until the next clock tick; in the meantime, the input token is provided to other elements of the digital electronic circuit, such as circuitry for input-consuming edges.

The current input token that is the output of the buffer is, until a next clock tick, provided to the logic in the circuitry for each input-consuming edge, each calling edge, and each returning edge. In the present example, the first input token is START, which is provided as output by the buffer on a first clock tick. The logic in the circuitry for each edge compares this input token with the input-consumption condition associated with that edge. Here, only input-consuming edge 1 has the input-consumption condition "INPUT==START". Therefore the register in the circuitry for input-consuming edge 1 will, upon the next (second) clock tick, go high and output a logical high to the circuitry for non-input-consuming edge 2, via the circuitry for vertex 226. The circuitry for all other edges will not provide a logical high after the second clock tick.

The buffer then moves on to the next input token, on the second clock tick. The next input token is DIGIT. This input token matches the input-consumption condition for input-consuming edge 13 but the circuitry for input-consuming edge 13 is not yet receiving a logical high from the circuitry for vertex 146, and so will not yet output logical high upon the next (third) clock tick. Non-input-consuming (calling) edges 2 and 8 both also check for the input-consumption condition "INPUT==DIGIT". The circuitry for calling edge 8 is not receiving logical high from the circuitry for vertex 166, and so does not output logical high. But, the circuitry for calling edge 2 is receiving a logical high from the circuitry for vertex 226, and so the circuitry for calling edge 2 provides a logical high to the circuitry to the circuitry for vertex 142. The circuitry for calling edge 2 also pushes to the stack a value indicative of the corresponding returning edge for that calling edge, which in this case is returning edge 5.

During the same clock cycle (i.e. before the third clock tick), the logical high output by the circuitry for calling edge 2 propagates to the OR gate in the circuitry for vertex 142, causing the OR gate to output logical high to the circuitry for both non-input-consuming edge 3 and non-input-consuming (calling) edge 4. For non-input-consuming edge 4, the present input token DIGIT does not match the calling-edge condition "INPUT==OPEN_BRACKET", and so the circuitry for non-input-consuming edge 4 does not output logical high. However, non-input-consuming edge 3 is an epsilon transition, and not a calling or returning edge, and therefore the circuitry for non-input-consuming edge 3 may be a simple coupling. The coupling of non-input-consuming edge 3 propagates the logical high signal to the circuitry for vertex 146, which in turn propagates the signal to the circuitry for input-consuming edge 13.

Input-consuming edge 13 now receives a logical high, and the input-consumption condition "INPUT==DIGIT" is matched by the current input token, therefore the circuitry for input-consuming edge 13 will output a logical high to the circuitry for vertex 148 after the next (third) clock tick. The propagation of the logical high signal through the digital electronic circuit 300 then pauses until the next clock tick.

On the next (third) clock tick, the buffer outputs the next input token, which in this case is EOF. The circuitry for input-consuming edge 13 outputs a logical high, which propagates via the circuitry for non-input-consuming edge 15 and the circuitry for vertex 144, and is therefore provided as input into the circuitry for each of non-input-consuming edges 5 and 9. The input token EOF does not match the calling-edge condition "INPUT=COMMA" or "INPUT=CLOSE_BRACKET" checked for by the circuitry for non-input-consuming edge 9, and therefore the circuitry for non-input-consuming edge 9 does not allow propagation of a logical high signal. Non-input-consuming edges 5 and 12 check for the condition "INPUT==EOF". The circuitry for non-input-consuming edge 12 is not receiving logical high from the circuitry for vertex 164, and therefore does not provide a logical high as output. The circuitry for non-input-consuming (returning) edge 5 is receiving a logical high from the circuitry for vertex 144. The circuitry for returning edge 5 therefore checks the stack (peeks at the top value on the stack) to ensure that a value indicative of the returning edge 5 is at the top of the stack. This is the case here, and so the circuitry for returning edge 5 pops that value from the stack, and outputs a logical high to the circuitry for vertex 228, which propagates the logical high to the circuitry for input-consuming edge 6. The input-consumption condition of input-consuming edge 6 "INPUT==EOF" is matched by the present input token, and therefore the register in the circuitry for input-consuming edge 6 will go high after the next (fourth) clock tick. The propagation of the logical high signal through the digital electronic circuit 300 then pauses until the next clock tick.

On the next (fourth) clock tick, the circuitry for input-consuming edge 6 outputs logical high to the circuitry for end vertex 124. When a logical high is detected at the output of the digital electronic circuit, i.e. the circuitry for the end vertex for the entire RTN (in this case end vertex 124), it can be concluded that the input data has successful parsed, and therefore the input data conforms to the grammar, provided that the logical high at the output occurs coincidently with the end of sequence of input tokens (i.e. when the last of the input data is or has been consumed). In the present example, on the fourth clock tick, the buffer does not include any input tokens which it can output, as the final token EOF was output on the previous (third) clock tick, and therefore the input-consumption condition of the end of the sequence of input token is met at the same time as the output of the digital electronic circuit going to logical high. It can therefore be concluded that the specific input data conforms with the data format corresponding to the grammar upon which the RTN is based. In the present example, the input data was START DIGIT EOF, which is an allowable stream of input tokens according to the grammar and RTN 200 of Figure 2.

Regardless of the input data that is used, the logical high signal can only propagate through the digital electronic circuit to the output of the digital electronic circuit coincidently with the last input token (i.e. when the last of the input data is or has been consumed) if the input data is or has been successfully parsed against the grammar. Therefore any arbitrary input data can be processed using the digital electronic circuit to determine if it conforms with the grammar. Input data that does not conform with the grammar is not successfully parsed and the logical high signal does not propagate to the output of the digital electronic circuit coincidently with the last input token. Therefore a digital electronic circuit produced according to the techniques of this disclosure may be able to determine whether or not input data conforms with the grammar upon which the RTN is based, and therefore whether or not the input data conforms with the data format (such as a particular JSON schema, for example) that the grammar defines. This may offer advantages for the large-scale processing of data because digital electronic circuits according to the techniques of this disclosure may be employed to check data prior to subsequent processing, which may reduce inefficiencies due to malformatted data and may allow rejection of data that potentially includes malicious code. Further, this check is performed using a digital electronic circuit, such as an FPGA. An FPGA by default is not a Turing-complete machine and so cannot be caused to execute arbitrary code such as any malicious code in the input data to be parsed. Therefore the techniques of this disclosure may offer security advantages compared with parsing input data using software running on a general-purpose computer.

As discussed above, the purpose of the pushing to the stack by the calling edge circuitry, and the checking (peeking) and popping by the returning edge circuitry, is to keep track of which embedded network of the RTN the propagating logical high signal is currently in during the parsing. In other words, the output of the digital circuit can only be a logical high, indicating a successful parse, if the correct number of calls and returns between embedded networks has been made. For example, the input data START OPEN_BRACKET DIGIT EOF is not allowed by the grammar of RTN 200 of Figure 2, as the necessary CLOSE_BRACKET is missing between DIGIT and EOF. However, during the parsing of this input data by the digital circuit, when the buffer outputs the DIGIT input token, a logical high voltage signal is received by the circuitry for non-input-consuming (returning) edge 5 after the next clock tick. Without the stack check, when the next input token EOF is output by the buffer, the non-input-consuming edge 5 would output logical high, which would result a logical high output at the circuitry for vertex 124, indicating a successful parse. The stack check ensures that after moving in the RTN 200 from the second embedded network 160 ('Array') into the first embedded network 140 ('Value'), a return is made back to the second embedded network 160 ('Array') as is required by the grammar, rather then jumping straight from the first embedded network 140 ('Value') to the first network 120 ('Top'). If the stack check fails, i.e. a value for that returning edge is not at the top of the stack, then logical high signal cannot propagate past the circuitry for the returning edge and thus a false positive validation result is prevented. However, as discussed below, the use of a stack is not essential for this function, particularly if it is known that an embedded network can only be called once during a parsing process before returning from that embedded network; in such cases the stack is unnecessary because there is no need to keep track of how many times the embedded network has been called and the particular calling edge and corresponding returning edge the embedded network has been called each on each occasion. The skilled reader will recognise that other memory hardware may be used to store the value for a returning edge in such circumstances, such as a register.

### Memory Implementation

The memory in the digital circuit specified by the hardware description may be implemented in a number of different ways. The memory is a stack in the example discussed above.

In some examples, a single 'global' stack may be used for all calling and returning edges. In other words, the circuitry for each calling edge is configured to push the value indicative of its corresponding returning edge to the top of a single stack shared by all of the calling edges, and the circuitry for each returning edge peeks from and pops from the same stack.

In some examples, it may be necessary for multiple hardware components of a digital electronic circuit to access the stack for pushing, peeking or popping within a single clock cycle. For example, in Figure 3, if the current input token output by the buffer is CLOSE_BRACKET, and the circuitry for input-consuming edge 11 is receiving a logical high from the circuitry for vertex 168, the register in the circuitry for input-consuming edge 11 will go high at the next clock tick, providing a logical high to the circuitry for non-input-consuming edge 12. If the next token output by the buffer is EOF, a peek and pop of the top value of the stack must be sequentially performed by the circuitry for non-input-consuming (returning) edge 12 and also by the circuitry for non-input-consuming (returning) edge 5, in order for a logical high signal to reach the circuitry for input-consuming edge 6. Such a situation may be addressed in multiple ways. For example, the digital electronic circuit may be configured to queue stack operations, and ensure that such stack operations are processed before a next clock tick. This can be done by configuring stack operations to run faster than the clock speed that is used for the processing of input tokens from the buffer, in order to permit multiple stack operations to take place in sequence (e.g. peeking or popping or pushing to a single stack from multiple locations in the digital electronic circuit) between each advance of the buffer output. Other embodiments include a mechanism to temporarily pause the processing of input tokens for one or more clock cycles and maintain logic values around the circuit until the required sequence of stack operations is complete.

Alternatively, one or more distributed local stacks may be used instead of or in addition to a global stack. In some embodiments, a local stack is provided for each embedded network of the RTN. The circuitry for each calling edge to a specific embedded network would push to the local stack for that embedded network, and the circuitry for each returning edge from that specific embedded network would peek and pop from the local stack for that embedded network.

To implement local stacks in the example of Figures 2 and 3, the hardware description could include instructions for two stacks: a first local stack corresponding to the first embedded network ('Value') 140, and a second local stack corresponding to the second embedded network ('Array') 160. The circuitry for calling edges 2 and 8 would be configured to push to the first stack, and the circuitry for returning edges 5 and 9 would be configured to peek and pop from the first stack. Similarly, the circuitry for calling edge 4 would push to the second stack, and the circuitry for returning 12 would peek and pop from the second stack.

Distributed local stacks may provide technical advantages relative to the use of a global stack. Distributed local stacks may reduce or avoid the need for multiple returning edges or calling edges to access a single stack in a single clock cycle, which can mean that the digital electronic circuit can be implemented without circuitry to pause the processing or ensure that multiple stack operations take place using a single stack in a single cycle, which may result in a more efficient hardware implementation or allow for greater data throughput. For example, for the path from non-input-consuming edge 12 to non-input-consuming edge 5 to input-consuming edge 6 discussed above for the global stack, which requires two stack pops, both stack pops may be performed at the same time using separate local stacks. Specifically, the peek and pop by the circuitry for the returning edge 12 can be performed at the first local stack at the same time and in the same clock cycle as the peek and pop by the circuitry for the returning edge 5 using a different local stack.

Thus having multiple stacks that can each be modified in a single clock cycle can lead to improved parsing performance, by avoiding stack-access bottlenecks that could occur with a global stack. The parsing performance may be improved because the digital electronic circuit can operate at a higher clock speed or can avoid a pausing and queuing mechanism as described above.

In addition, the use of distributed local stacks may avoid the need for large combinational logic functions for stack push, peek and pop operations in the circuitry for the calling and returning edges. Larger combinational logic functions reduce the maximum viable clock speed for the digital electronic circuit, and therefore further limit the speed at which data can be parsed in the digital electronic circuit.

Moreover, local stacks for each embedded network can be located more optimally within the digital electronic circuit, such as nearby to the circuitry for calling edges and returning edges that access the local stack. By contrast, a single global stack can only be located at one position within the digital electronic circuit, leading to a more topologically complicated routing of paths and physically longer conductive paths in the digital electronic circuit, which can increase propagation times between circuit elements and further reduce the maximum clock speed.

Moreover, the use of multiple local stacks may require a smaller amount of storage in total, relative to a global stack, and therefore may be more efficient to implement. This is because each local stack may only require enough storage to represent the total number of calling contexts for its associated embedded network.

The advantages of multiple distributed local stacks compared to a single global stack may be more pronounced for larger and/or more complex grammars.

In some examples, the digital electronic circuit may use a combination of one or more local stacks and one or more global or 'shared' stacks. For example, the digital electronic circuit may use a respective local stack for each of one or more embedded networks, and well as one or more shared stacks that are each used by multiple other embedded networks.

In recursive calling contexts, there might be no limit to the number of times that an embedded network could be recursively called within itself. Because of this, an infinite stack depth would be needed to facilitate all possible input data that conforms to the grammar. For practical implementations, whenever a stack is used in a recursive context, a stack depth must be chosen that limits the number of nested recursive calls that can be made. In such a case, the limit would prevent a digital electronic circuit from parsing the recursive calling of this embedded network a number of times greater than the stack depth. Therefore the parse would fail if the stack depth limit is or would be exceeded, e.g. if a value is pushed to a stack that is already full.

While some embodiments employ a stack, other embodiments include calling and returning edges that are not implemented using a stack. In some embodiments, if an embedded network in the RTN always returns before it is called again, a simpler memory implementation such as a register is used instead of a local stack for that embedded network. Specifically, if an embedded network cannot be called a second time after a first call, unless a return has been made following the first call, then the stack is only required to have a stack depth of one. This situation may arise where an embedded network is embedded at one or more locations within an RTN, but the embedded network is not embedded within itself, either directly or indirectly. Therefore the memory to store a value indicative of a returning edge from that embedded network may be implemented as a register.

### Inlining Embedded Networks

In some examples, one or more embedded networks may be 'inlined' in the generated hardware description and any corresponding digital electronic circuit implemented based on the hardware description. Inlining comprises a processing operation performed on a digitally stored RTN before generating a hardware description based on the RTN in which one or more embedded networks are 'inlined'. The use of the term 'inlining' in the present application is analogous to its use in software optimization, where the calling of a function at a location in code is replaced by the content of that function at that location. If an embedded network is inlined, then that embedded network is not called from the network within which it is embedded but instead its content is inserted directly into the network within which that embedded network was embedded.

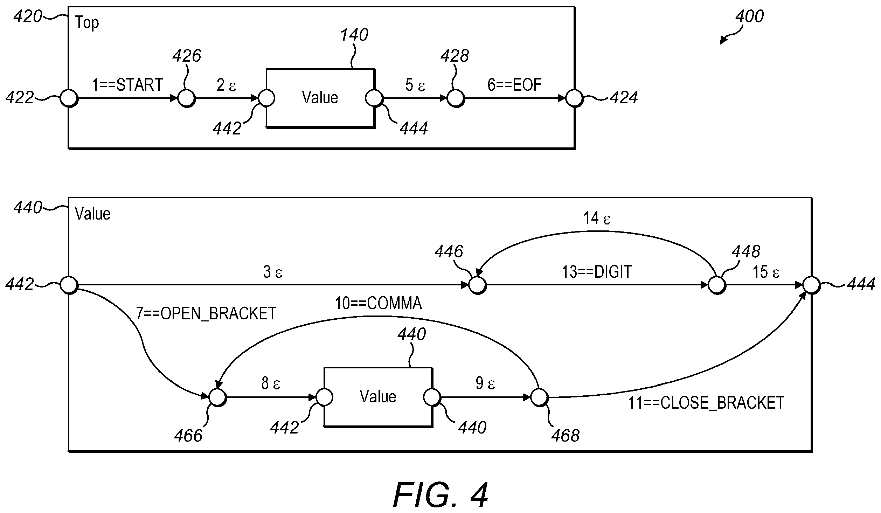

For example, in cases where an embedded network is only called in a single context, i.e. at only one location in the RTN, that embedded network can be inlined. In the RTN 200 of Figure 2, the second embedded network 160 ('Array') is only called from the first embedded network 140 ('Value'). Therefore the second embedded network 160 can be subsumed into first embedded network 140. Figure 4 shows the RTN resulting from this process. The RTN 400 shown in Figure 4 is identical to RTN 200 of Figure 2, except for the inlining of the second embedded network 160 ('Array'). The non-input-consuming edges 4 and 12, which were added in Figure 2 to ensure that the calling and returning edges in the RTN 200 were epsilon transitions, have been removed in the RTN 400 of Figure 4. This is because there are no longer calling or returning edges for the second embedded network 160 ('Array') of Figure 2. The RTN 400 of Figure 4 has epsilon transitions for the calling and returning edges 2 and 5 for the embedded network 440 ('Value'). Analogous reference numerals have been used for the RTN 400 of Figure 4.

The RTN 400 of Figure 4 represents the same grammar as the RTN 200 of Figure 2 but contains fewer overall directed edges and vertices and fewer calls and returns from embedded networks. Therefore the digital electronic circuit implementing the RTN 400 may advantageously require less logical circuitry due to the inlining performed, as well as less memory due to the lower number of calls/returns and thus lower requirements to store values indicative of returning edges.

A hardware description can be generated for the RTN 400 using the same steps and rules as outlined above for Figures 2 and 3, allowing the RTN 400 to be implemented as a digital electronic circuit to perform parsing according to the grammar upon which the RTN 400 is based.

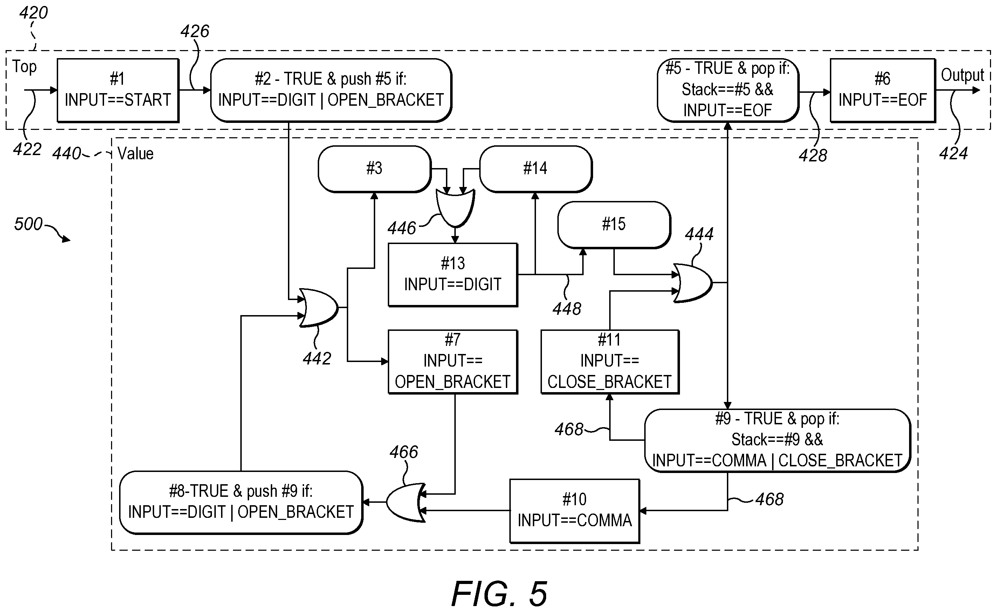

Figure 5 shows a schematic logical diagram of a digital electronic circuit 500 according to the hardware description generated from the RTN 400 upon which inlining has been performed in accordance with the above-described steps. The operation of digital electronic circuit 500 is analogous to the operation of the digital electronic circuit 300 of Figure 3, although may provide advantages relative to digital electronic circuit 300 in terms of reduced amount of logical circuitry and/or reduced memory requirements.

For embedded networks that are called in multiple contexts, i.e. called at multiple different locations in the RTN, such embedded networks can still be inlined. However, inlining such embedded networks only provide inlining benefits at the location at which they are inlined. Therefore for the greatest inlining benefit, such embedded networks are inlined at each location in the RTN separately. This means that the circuitry implementing the embedded network in the digital electronic circuit must be included separately for each calling context, i.e. at each relevant location within the circuit. In practice there may be a limit to the size or number of components of a digital electronic circuit, which may limit the degree to which inlining may be performed. Moreover, inlining recursively called embedded networks faces additional restrictions as discussed below.

In general, inlining an embedded network that is called from multiple different locations at those multiple different locations may be particularly advantageous if that embedded network is relatively small, such that the increased circuitry caused by the inlining at multiple different locations remains relatively small, although larger embedded networks may be inlined if the resulting digital electronic circuit would remain within size limits.

Inlining may also be used for an embedded network in a recursive calling context. However, physical constraints would prevent an embedded network being recursively inlined a number of times without limit. For example, in the RTN 400 of Figure 4, there is no limit to the number of times that the embedded network 440 ('Value') could be recursively called within itself, and therefore no limit to the number of times the embedded network 440 ('Value') could be inlined. In a practical implementation, a recursion limit must be chosen (in the same way that a stack depth must be chosen when using a stack to keep track of calls and returns to/from a recursively embedded network). The recursion limit may be a predetermined maximum recursion depth that is the maximum number of times that a recursively called embedded network may be inlined within itself. The recursion limit might be a number such as five or ten, although the particular number used may depend on hardware constraints of the digital electronic circuit, such as FPGA capacity. The recursion limit may permit the embedded network 440 to be inlined within itself a maximum of five ten times. In some examples, the data format might specify a maximum number of levels of recursion and so requirements for inlining a recursively embedded network may be known when generating the hardware description and decisions on whether or not to inline an embedded network and a number of levels of inlining to perform may be made based on this knowledge.

### Calling/Returning Edge Optimisation

In some embodiments, optimisations can be made to the logic in the calling and returning edges.

For the calling edges described above, a call from a network to an embedded network requires storing in memory (e.g. a stack or a register) the identity of the corresponding returning edge that will be followed on return from that embedded network. There is performed a check that the current input token provided by the buffer will be consumed by (i.e. match the input-consumption condition of) one of the immediately subsequent (downstream) input-consuming edges that follow the calling edge in the RTN.

In some situations, an optimisation may be made to omit the check that the current input token provided by the buffer will be consumed by one of the immediately subsequent input-consuming edges. In a resulting digital electronic circuit, an incoming logical high signal to the circuitry for the calling edge is always propagated and the identity of the corresponding returning edge stored in memory.

This optimisation to omit a check of the input token being consumed downstream of the corresponding returning edge is not required in the case where there is no alternative transition to the calling edge that could progress the parse. Specifically, the check that the input token will be consumed downstream of the corresponding returning edge is not required if there are no other edges competing with a calling edge in the RTN to continue the parse, i.e. there are no other edges sharing the same source vertex as the calling edge (and therefore no other edges branching off from the same source vertex as the calling edge). In such a case the circuitry for the calling edge always propagates a received logical high signal and stores the identity of the corresponding returning edge.

For the returning edges, a return from an embedded network to the network within which it is embedded requires a check that the value indicative of that returning edge is stored in the associated memory (e.g. present at the top of the stack). Further, there is performed a check that the current input token output by the buffer will be consumed by (match the input-consumption condition of) one of the immediately subsequent input-consuming edges that is downstream of the returning edge in the RTN.

However, in certain situations the check that the current input token provided by the buffer will be consumed by one of the immediately subsequent input-consuming edges can be omitted, and an incoming logical high signal is propagated by the circuitry for the returning edge only dependent on the check of the memory contents (e.g. value on top of the stack).

This check of the input token being consumed is not required in the case where there is no alternative transition to the returning edge that could progress the parse, except for other returning edges. Specifically, the check of the input token is not required if there are no other edges competing with a returning edge in the RTN to continue the parse, except for other returning edges. In other words, there are no other edges sharing the same source vertex as the returning edge (and therefore no other edges branching off from the same source vertex as the returning edge), except for any other returning edges. In such a case, the stack popping operation occurs without any input token check, and the circuitry for the returning edge propagates a received logical high signal dependent only on the check that the value indicative of that returning edge is present at the top of the stack.

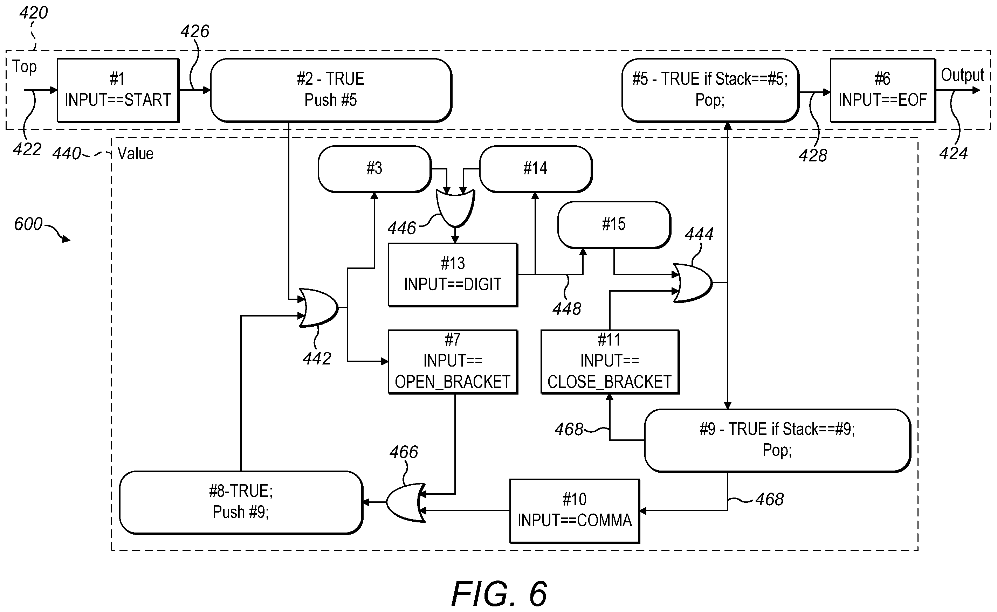

Figure 6 shows a schematic logical diagram of a digital electronic circuit 600 according to the hardware description generated from the RTN 400 of Figure 4 with the above described optimisations being applied. As can be seen in Figure 6, the circuitry for calling edges 2 and 8 does not include the checking of the current input token operation. This is because in the RTN 400 of Figure 4, neither of calling edges 2 or 8 have competing edges, i.e. other edges sharing the same source vertex 426/466.

Further, as can be seen in Figure 6, the circuitry for returning edges 5 and 9 does not include the checking of the current input token operation. This is because in the RTN 400 of Figure 4, for returning edge 5 the only competing edge (i.e. edge also having source vertex 444) is returning edge 9, and vice versa. There is no non-returning edge with vertex 444 as a source vertex.

The reader will note that, although a competing edge is described as one sharing the same source vertex in the description above, two edges are also competing edges if the source vertex for one of the edges is connected to the source vertex for the other edge by a path that allows transition unconditionally (e.g. a path consisting only of epsilon transitions). This is because the implemented circuitry for both vertices would be logically high at the same time.

In general terms, the generated hardware description can either be entirely optimised as outlined above (with no input token checks on the calling and returning edges), or entirely non-optimised (with input token checks on every calling and returning edge). The degree to which optimisations may be made will depend on the specific grammar. In some embodiments, the generated hardware description includes both optimised and non-optimised calling and returning edges, where some of the calling and returning edges perform checks based on the current input token and some of the calling and returning edges do not perform such checks.

### LL(*) Grammars

The preceding description has so far considered methods and techniques of generating a hardware description for configuring a digital electronic circuit to parse input data against LL(1) grammars. The above described methods and techniques may also be applied to LL(*) grammars.

Unlike LL(1) grammars, where resolving which of several grammar rules to take at a given point in a parse requires looking ahead by at most one input token in the input data sequence, LL(*) grammars (that are not LL(1)) require looking ahead by more than one input token in the input data sequence to resolve which grammar rule should be taken at certain points in the parse.

LL(*) grammas may also be represented using transition networks such as RTNs. For LL(1) grammars, the single input token look-ahead requirement means that at any given source vertex for a calling edge in an RTN representing that grammar, there is at most only one path that can be taken based on the next input token. In other words, when the parse reaches a calling edge it will always be apparent from the next input token whether that calling edge should be transitioned, or whether a competing edge (i.e. an input-consuming edge or another calling edge having the same source vertex) should be transitioned. For LL(*) grammars this is not the case, as the multiple input token look-ahead requirement means that at a given source vertex for a calling edge, there may be ambiguity based on the next input token alone as to whether that calling edge should be transitioned next in the parse or whether a competing edge should be transitioned. For example, in an LL(*) grammar two calling edges sharing the same source vertex could both be followed downstream by input-consuming edges that have the same associated input-consumption condition. Further, in an LL(*) grammar a calling edge could share the same source vertex as an input-consuming edge, and that input consuming edge could have the same input-consumption condition as the input-consuming edge downstream of the calling edge. Thus when using an RTN to parse input data against an LL(*) grammar, two or more different paths can advance in different networks within the RTN simultaneously (e.g. simultaneously in two different embedded networks or in simultaneously an embedded network and the network in which it is embedded). Such a situation is an example of a non-deterministic state. Specially, in LL(*) grammars there can be non-determinism at the point in which an embedded network is called.

In general, for LL(*) grammars, determining which of several grammar rules to take at an ambiguous point can be resolved by comparing the look-ahead sequence of upcoming input tokens in the input data against a set of regular expressions. Specifically, each grammar rule under consideration has a corresponding regular expression which indicates that that grammar rule should be taken when the regular expression matches the upcoming input token sequence.

For example, a simple grammar in shown in Table 2:

**TABLE 2**

| |
|---|
| TOP : A \| B |
| A : a b c d |
| B : a b d e |

Resolving which of Rule A or Rule B to take in the Rule TOP requires looking ahead at the upcoming sequence of input tokens. The regular expressions for predicting whether Rule A or Rule B should be taken when in Rule TOP are as follows:
TOP.A : a b c
TOP.B : a b d

For the grammar of Table 2, the look-ahead required to resolve which of Rule A or Rule B to take is finite, requiring a look-ahead of three input tokens. The look-ahead will always be finite for all LL(k) grammars (for all positive integer k), which are a subset of all LL(*) grammars. However, some LL(*) grammars allow for the possibility of indefinitely long sequences of input tokens before rule selection is resolved.

For example, another simple grammar in shown in Table 3:

**TABLE 3**

| |
|---|
| TOP : A B |
| A : (d e?)+ e f |
| B : e? (d e)+ e e |

The grammar of Table 3 requires potentially infinite look-ahead to resolve which of Rule A or Rule B to take, with the regular expressions for predicting whether Rule A or Rule B should be taken when in Rule TOP being:
TOP.A : (d e?)+ e f
TOP.B : e | (d e)+ e e

When parsing data against an LL(*) grammar (that is not LL(1)), if multiple grammar rules could be applied then the correct grammar rule to take remains ambiguous if only a single input token look-ahead is used, as would be the case for an LL(1) parser. Conventional approaches for parsing against LL(*) grammars involve buffering the upcoming sequence of multiple look-ahead input tokens and iteratively comparing this buffered sequence of tokens against the set of regular expressions for all grammar rules which may be applied at that ambiguous point, until resolution of the correct rule is complete. Typically such analysis is performed using deterministic finite automata (DFAs). Such techniques have a number of drawbacks:
- Large buffers may be required to hold the necessary look-ahead input token sequences.
- The regular expression state space may be large and computationally expensive to explore.
- Such comparison of the set of regular expressions against the buffered look-ahead sequence needs to be completed before the parse can continue, which can result in having to pause the processing of the input data sequence until the ambiguity in which rule to take has been resolved.

However, applying the techniques of this disclosure discussed previously to LL(*) grammars can overcome each of these drawbacks.

### Hardware Implementation of RTN for LL(*) Grammar

The techniques and methods described above for LL(1) grammars can be applied without modification to a subset of all possible LL(*) grammars. The subset of LL(*) grammars consists of all LL(*) grammars which meet the following condition:
- In an RTN representation of the grammar, for all input data that conforms to the LL(*) grammar, during parsing of the sequence of input tokens of the input data against the grammar, after a first embedded-network-calling edge to any embedded network within the RTN is transitioned, no embedded-network-calling edges to that embedded network are subsequently transitioned until either 1) the embedded-network-returning edge corresponding to the first embedded-network-calling edge has been transitioned or 2) that embedded network has fallen out of state.

### CONDITION 1

By "the embedded network has network fallen out of state", it is meant that the parse reaches a state where no input-consuming edge within that embedded network can be transitioned for the next input token. Put another way, an embedded network falls out of state when within that embedded network, during the parse, a state is reached where none of the upcoming input-consuming edges can be transitioned. Specifically, during a parse the state is defined by which vertex (or vertices in the case of ambiguity) has been reached in the embedded network according to the previously consumed input tokens. The embedded network falls out of state when none of the input-consumption conditions are met for any input-consuming edges immediately downstream of that vertex (or vertices). By input-consuming edges immediately downstream it is meant any input-consuming edges having that vertex as a source vertex, or any input-consuming edges having that vertex separated from its source vertex only by non-input consuming edges (epsilon transitions). In other words, the embedded network has fallen out of state when there is no way to continue parsing against the RTN within that embedded network.

By "no embedded-network-calling edges to that embedded network are subsequently transitioned", it is meant that neither the first embedded-network-calling edge itself, nor any other calling edge to that embedded network from a different context may be transitioned until one of situations 1) or 2) has occurred.

Condition 1 necessarily excludes LL(*) grammars that are represented by an RTN having a recursively embedded network. Specifically, if the first embedded-network-calling edge cannot be called again until the corresponding first embedded-network-returning edge has been transitioned, this precludes the embedded network from being directly embedded within itself, or indirectly embedded within itself via another network.

For some LL(*) grammars, when a parse is in a non-deterministic state with multiple paths advancing through different networks in the RTN simultaneously, if a call to an embedded network has been made, a further call could be made to that embedded network (whether via the first embedded-network-calling edge or via a calling edge to that embedded network from a different context). As well as excluding recursively embedded networks, Condition 1 prevents such a further call from being made from other non-deterministic paths advancing in parallel through the RTN, unless the initial call has already returned, or the initial call was made on a non-deterministic path through the RTN which has since ceased (i.e. fallen out of state) due to input-consumption conditions not being met.

As mentioned, for LL(*) grammars represented by an transition network (such as an RTN) that meets Condition 1, the techniques described for LL(1) grammars may be applied analogously to generate a hardware description for configuring a digital electronic circuit to parse input data against the LL(*) grammar. In particular, instructions for an input buffer, instructions for a memory, and instructions for circuitry corresponding to each of the edges and each of the vertices of the RTN for the LL(*) grammar can be included in the hardware description exactly as described above for the LL(1) example. The hardware description for the LL(*) grammar may differ in some embodiments only in relation to the implementation of the memory for the calling and returning edge circuitry, as discussed below.

### Memory Implementation for LL(*) Grammars

As with the previous LL(1) examples, in a digital electronic circuit implemented according to the hardware description generated for an LL(*) grammar, the memory is used to track calls to embedded networks within the RTN and to direct corresponding returns from those embedded networks. The memory is configured to store a value and provide the stored value as output from the memory. The memory for the calling and returning edge circuitry can be implemented in an number of different ways.

Firstly, as noted Condition 1 for the subset of LL(*) grammars being considered excludes recursively embedded networks. Therefore a stack implementation is not required for the memory for the calling and returning edges. Instead, as with LL(1) grammars that have an embedded network that always returns before it is called again, the memory for the calling and returning edge circuitry may be implemented as simpler memory, such as a register or the like.

In some embodiments, the hardware description may include instructions for providing a respective memory for each embedded network in the RTN, such as a separate register for each embedded network in the RTN. All calling edges to a particular embedded network, i.e. all calling edges having a destination vertex which is the start vertex of that embedded network, are associated with the memory for that embedded network, such that the circuitry for each of those calling edges is configured to store a value in that associated memory in response to the implemented circuitry for the source vertex of that calling edge providing a logical high. Similarly, all returning edges from a particular embedded network, i.e. all returning edges having a source vertex which is the end vertex of that embedded network, are also associated with the memory for that embedded network, such that the circuitry for each of those returning edges is configured to retrieve the value stored in that associated memory when checking if a call corresponding that returning edge has been made.

As described previously for the LL(1) example, the circuitry for each calling edge may comprise logic to store in the associated memory a value indicative of the corresponding returning edge for that calling edge, such as the identifier of the corresponding returning edge. The circuitry for the each returning edge may then only propagate the logical high signal onward through the digital electronic circuit if it retrieves from the associated memory a value indicative of that returning edge. In this way, the parse can only successfully return from the embedded network along the returning edge that corresponds to the last call that was made to the embedded network.

When a call is made to an embedded network, and a value is stored in the associated memory by the circuitry for that calling edge, that value needs to be provided as output by the memory until the corresponding return has been made where that value is checked by the returning edge circuitry. This may involve the memory providing the value as output over multiple clock cycles. In embodiments, each associated memory may provide the stored value as output continuously until a later call is made to that embedded network.

In the case that, during the parse, a later call is made to the same embedded network, i.e. circuitry for a calling edge to that embedded network receives a logical high signal after an initial call to that embedded network has previously been made, the circuitry for that calling edge is configured to overwrite any current value stored in the memory for that embedded network. It is noted Condition 1 for the subset of LL(*) grammars prevents any value stored in the memory for an initial call from being overwritten unless the return corresponding to that call has already been made, or unless the logical high signal propagating following that call has since ceased due to no further input-consumption conditions being met. The latter situation may occur due to the propagating signal being a non-deterministic path due to earlier ambiguity, that is then resolved as not the correct parse according to the grammar once further input tokens have been processed.

In some embodiments, values other than the identifier for the corresponding embedded-network-returning edge may be stored in and retrieved from the memory by the circuitry for the calling and returning edges. In general, any value that is indicative of that embedded-network-calling edge having been transitioned may be stored in and retrieved from the memory by the circuitry for the calling and returning edges, to track calls to and direct corresponding returns from embedded networks within the RTN. This value can also be referred to as storing the "calling context".

A value indicative of the corresponding returning edge for a given calling edge, such as the identifier for that returning edge, is one example of a value indicative of that embedded-network-calling edge having been transitioned. It is noted that a value indicative of a corresponding returning edge for a calling edge is inherently a value indicative of that calling edge having been transitioned. Similarly, a value indicative of a calling edge having been transitioned is inherently a value indicative of the corresponding returning edge for that calling edge, as each calling edge has one corresponding returning edge.

In other embodiments, the circuitry for each calling edge can be configured to store the identifier of the calling edge itself as the value indicative of that embedded-network-calling edge having been transitioned. The circuitry for each returning edge is then configured to allow the propagation of the logical high signal onwards in the digital electronic circuit only if it retrieves from the memory the identifier for the calling edge which corresponds to that returning edge.

In other embodiments, the circuitry for each calling edge can be configured to store an identifier of the network from which the call was made (i.e. the network having the source vertex for that calling edge) as the value indicative of that embedded-network-calling edge having been transitioned. For example, consider an embedded network X which is embedded in and thus called from both network A and network B. The circuitry for the calling edge from network A to X may store within the memory for embedded network X "A" as the value indicative of that calling edge having been transitioned. The circuitry for the calling edge from network B to X may store within the memory for embedded network X "B" as the value indicative of that calling edge having been transitioned. The corresponding returning edge circuitry will only allow the logical high signal to propagate if the identifier for the network that returning edge returns to is stored. However, storing the calling context in this manner is only possible if embedded network X is only embedded in each of networks A and B once. If embedded network X was embedded in either of A or B more than once, merely knowing which network the calling edge originated from would not be sufficient to know which returning edge corresponds to that calling edge. In such cases the identifier of the specific calling edge (or corresponding returning edge) would be needed as the value indicative of that embedded-network-calling edge having been transitioned.

For some LL(*) grammars, simultaneous calls (i.e. calls made on the same clock tick) can be made to the same embedded network via multiple different calling edges, due to multiple paths advancing through the RTN in a non-deterministic state. In such cases, when the calling edges are associated with the same memory, the memory can be implemented to store the calling contexts for each of these multiple calling edges together when the circuitry for the calling edges simultaneously instruct storing of their respective calling context. As before, the calling contexts may be the identifiers for each returning edge corresponding to the multiple calling edges (or any of the other calling contexts described above). The circuitry for the returning edges corresponding to those calling edges can be configured to allow the logical high signal to propagate if any one of the stored values is a value indicative of that retuning edge (or indicative of its corresponding calling edge having being transitioned). As before, the memory would be overwritten entirely if any new call is made to the embedded network at a later time.

In some embodiments, instead of having a respective memory for each embedded network in the RTN, the hardware description may include instructions for providing a respective memory for each calling edge in the RTN. Such a memory implementation may include a separate dedicated memory associated with each calling edge, such as a separate register for each calling edge in the RTN. In such embodiments, the implemented memory thus includes a set of memories (e.g. registers) for each embedded network of the RTN, with each memory associated with one of the calling edges to that embedded network. When registers are used, each register can be referred to as a "calling context register", and the set of registers for all calling edges may be referred to as the "calling context registers".

In such embodiments, when an embedded network X is called from a network A, the circuitry for the calling edge from network A to X is configured to store one of the calling context values described above in the respective memory associated with that calling edge, in response to the implemented circuitry for the source vertex of that calling edge providing a logical high signal. Such storing overwrites any previous value stored in that respective memory for that calling edge. Further, when storing the calling context value, the implemented circuitry for that embedded-network-calling edge is further configured to clear any previous values stored in any memory associated with any other calling edge to that embedded network, i.e. any other calling edge that has the same destination vertex, namely the start vertex of the embedded network.

If multiple calls to an embedded network are made simultaneously, each calling context value is stored in the respective memory simultaneously by the respective circuitry for each of the calling edges being transitioned. The memories associated with all other calling edges to that embedded network (excluding the multiple calling edges being simultaneously transitioned) are cleared. For example consider an embedded network X that is embedded within three different networks A, B and C in an RTN. If embedded network X is called simultaneously from networks A and B during a parse, then the circuitry for the calling edge from network A to X and the circuitry for the calling edge from network B to X will both store the calling context value in their respective memory. Further, the respective memory for the calling edge from network C to X will be cleared.

In embodiments where a respective memory is implemented for each calling edge in the RTN, a further simplification can be made to the storing of the calling context. In such embodiments it is not necessary to store an identifier for that calling edge or corresponding returning edge, or an identifier for the network from which the call originated. Instead, the storage of any value within the respective memory (e.g. register) for a calling edge is sufficient to indicate that that calling edge has been transitioned, due to the one to one mapping between the calling edges and the respective associated memories. Therefore, the storing of the value indicative of that embedded-network-calling edge having been transitioned may involve storing a first value, such as 1. Further, clearing any previous values stored in any memory in such embodiments may include overwriting the previous values by storing a second value, such as 0. If the respective memory for a calling edge has the first value stored thereon, then this indicates that a call has been made via that calling edge, and it can be immediately inferred that a return should later be made via the returning edge corresponding to that calling edge. In this way, the stored value is both indicative of that embedded-network-calling edge having been transitioned, and indicative of the corresponding embedded-network-returning edge (again because each calling edge has one corresponding returning edge).

It is noted that for any of the memory implementations described above, no matter which specific memory implementation is used, at any point in the parse the set of calling context values stored in all implemented memories and the set of values stored in the registers in the circuitry for all input-consuming edges represents state of the parse.

As mentioned above, the memories (e.g. calling context registers) may be configured to provide the calling contexts as output over multiple clock cycles, until a later call is made to that embedded network and the calling contexts are cleared from the memory or overwritten. In contrast, the registers in the circuitry for the input-consuming edges are configured to output a logical high signal for the duration that the next input token is output by the buffer, typically for the duration of the next clock cycle.

For a digital electronic circuit produced according to a hardware description generated for an LL(*) grammar according to the any of the above described methods, parsing of input data by the digital electronic circuit would progress analogously to the parsing process described for the LL(1) example previously, with reference to Figures 3, 5 and 6. In particular, a logical high signal will propagate through the circuitry according to input-consumption conditions matching the current input token output by the buffer. During the parse, the circuitry for any calling edges that receive a logical high signal will store the appropriate calling context in the associated memory when a call to an embedded network is made via that calling edge. The circuitry for any returning edges that receive a logical high signal will only allow further propagation of the logical high signal if the appropriate calling context is stored in the associated memory due to an earlier call via the corresponding calling edge.

However, unlike the LL(1) case, as the parse progress there can be ambiguity in which of multiple alternative grammar rules to take according to the LL(*) grammar based on the next input token. In the digital electronic circuit this results in multiple logical high signals propagating through the circuitry for different networks in parallel, due to input-consumption conditions being matched for input-consuming edges along each path. As the parse progresses, some or all of these logical high signals propagating in parallel will stop propagating due to input-consumption conditions not being met for the current input token (i.e. those propagating paths fall out of state). For input data that conforms to the LL(*) grammar, at least one of these parallel propagating paths will successfully propagate through the digital electronic circuit to reach the circuitry for end vertex of the RTN, indicating a successful parse, analogous to the LL(1) example.

When multiple logical high signals are propagating in parallel through the circuit, each propagating logical high signal can independently reach circuitry for a calling edge, which will store the calling context in the associated memory so it can be checked by the circuitry for the corresponding returning edge. In the case that both parallel logical high signals reach the circuitry for calling edges to the same embedded network simultaneously, the calling context is stored by the circuitry for both calling edges, as discussed previously. Both logical high signals may then be simultaneously propagated by the circuitry for the corresponding returning edges in parallel when the return from the embedded network is made.

In the case that the two logical highs signals propagating in parallel reach circuitry for calling edges to the same embedded network at different (non-simultaneous) times, the subset of LL(*) grammas defined by Condition 1 above ensures that storing the calling context for the later call does not overwrite the stored calling context for the earlier call unless the return corresponding to the earlier call has already been made, or the propagating signal that made the earlier call has since stopped propagating. For LL(*) grammars outside of the subset, the stored calling context for the earlier call could be overwritten before it had been used in the corresponding return, or before it is known that that calling context is not needed (due to that path falling out of state), which could lead to an erroneous parsing result.

A digital electronic circuit implemented according to the generated hardware description overcomes the previously identified drawbacks with known LL(*) parsers. In particular, rather than having to perform any look-ahead method at ambiguous points in the parse, the digital electronic circuit can continue to process the stream of input tokens without any pause or look-ahead. When there is ambiguity in the grammar, the digital electronic circuit in effect explores all parsing possibilities in parallel, with one logical high signal propagating through the digital electronic circuit for each possibility. Thus as well as providing the benefits discussed previously for the LL(1) example, namely avoiding the risks associated with software parsing whilst maintaining flexibility when using a hardware implementation, the techniques described herein provide a hardware implemented LL(*) parser that dispenses with the need for look-ahead token buffering and corresponding regular expression processing.

In general, all of the optimisations described above for the LL(1) example may also be made analogously in the case of an LL(*) grammar. For example, in some embodiments, the circuitry for the calling edges may include a check that the current input token provided by the buffer will be consumed by one of the immediately subsequent (downstream) input-consuming edges, particularly in the case that other edges share the same source vertex as the calling edge. Alternatively, this check may be omitted in the case where there is no alternative transition to the calling edge that could progress the parse.

The above described methods and techniques can also be applied to all LL(*) grammars represented by an RTN that does not have any embedded networks. This may include an RTN formed by fully inlining all embedded networks in an initial RTN (that does not include any recursively embedded networks), such that the resulting RTN does not have any remaining embedded networks. In such cases the hardware description can be generated with instructions for an input buffer and instructions for circuitry corresponding to each of the edges and each of the vertices of the RTN for the LL(*) grammar, exactly as described previously for the LL(1) example. As the RTN does not include any calling edges or returning edges in the RTN, no calling edge circuitry or returning edge circuitry or memory implementation is needed in the hardware description.

### Extension to other LL(*) Grammars

Techniques will now be discussed for generating a hardware description for all other LL(*) grammars that do not abide by Condition 1.

There are two types of LL(*) grammar which are non-compliant with Condition 1:
- Grammars with an RTN representation having an embedded network A that is not recursively embedded, but, for some input data conforming to the grammar, embedded network A is called multiple times non-simultaneously on alternative paths in a non-deterministic section of the grammar, with the subsequent call occurring before the return corresponding to the initial call has been made or before that embedded network has fallen out of state. ("Scenario 1")
- Grammars with an RTN representation having an embedded network A that is recursively embedded (whether directly embedded within itself or indirectly embedded within itself via another network). ("Scenario 2")

Grammars falling under Scenario 1 can be accommodated using the above described methods and techniques, along with an additional duplication step for embedded network A. The additional duplication step involves implementing multiple copies of the entire circuitry for the embedded network A and its calling and returning edges in the hardware description, and arranging the circuitry such that each logical high signal propagating in parallel (due to non-determinism at the point where embedded network A is called) passes through its own respective duplicate version of the embedded network circuitry. This ensures that no one duplicated version of the embedded network circuitry receives a logical high signal in a subsequent call, before the earlier logical high signal propagating through that version has either returned from that version of the circuitry, or has stopped propagating (fallen out of state).

Such a duplication step prevents a calling context from being overwritten before it had been used in the corresponding return, or before it is known that that calling context is not needed (due to that path falling out of state). This could otherwise lead to an erroneous parsing result.

This duplication step can be performed in two ways. In one embodiment, the duplication step can be effected by performing a refactoring of the grammar rules, such that Condition 1 now holds true for the refactored grammar. For example, calls to a Rule A within the grammar can be replaced with either a Rule A' or a Rule A", both of which are replicas of A. The techniques described above for the subset of grammars for which Condition 1 holds can now be applied analogously to the refactored grammar, including for Rules A' and A". Such a grammar refactoring can be performed prior to the generation of the hardware description, with an RTN representing the refactored grammar being provided as the digitally stored graph used to generate the hardware description.

In an alternative embodiment, instead of refactoring the grammar rules, an RTN representing the original grammar may be provided as the digitally stored graph used to generate the hardware description, and the duplication step can occur during the generation of the hardware description itself. In such an embodiment, generating the hardware description comprises implementing duplicate circuitry for an embedded network of the RTN, and arranging the duplicate circuitry in the hardware description such that each version of the duplicated circuitry does not receive a subsequent logical high signal from any calling edge circuitry following an initial logical high signal received from any calling edge circuitry, until after the initial logical high signal propagating through that version has stopped propagating, or has been propagated by circuitry for a returning edge for that version. Such duplicate circuitry for the embedded network may include duplicated circuitry for the calling edges to and returning edges from that embedded network.

Identification of which embedded networks in an RTN representing an LL(*) grammar fall under Scenario 1 (i.e. do not conform to Condition 1) can be determined using deterministic finite automaton (DFA) analysis on the RTN.

### Scenario 2: LL(*) grammars with recursively embedded networks

Grammars falling under Scenario 2 can be accommodated using the above described methods and techniques, along with the following modification: For a recursively embedded network A, identify the point (or points) in the parse where the non-determinism in calling embedded network A is resolved and push the stored calling context (e.g. from the calling context registers) for embedded network A to a stack at that point.

Comparing this approach to the stack solution described for recursive LL(1) grammars, for LL(1) there is no non-deterministic region coincident with calling recursive embedded network A, and we dispense with storing the calling context in a register associated with that calling edge, i.e. we dispense with the calling context registers entirely. Instead the calling context, e.g. the value indicative of the corresponding returning edge, is pushed to a stack immediately when embedded network A is called. By contrast, the strategy for LL(*) grammars is to defer the stack push until the non-determinism is resolved, i.e. until it is clear that the call is necessary for a correct parse against the grammar. This prevents speculative calls being erroneously stored in the stack, which could lead to erroneous parsing outcomes.

For an embodiment where a calling context register is implemented for each calling edge, and the calling edge circuitry is configured to store a first value of 1 as the value indicative of that calling edge having being transitioned (i.e. as the calling context), a call in an LL(*) grammar for a recursively embedded network will proceed as follows:
- Recursively embedded network A is speculatively called in context X (i.e. from network X), and the calling context is held in the associated calling context register, indicating the calling edge between network X and A has been transitioned. By speculatively, it is meant that the call is made on one of many paths advancing due to non-determinism.
- If the call to embedded network A is still alive (i.e. has not fallen out of state) when the non-determinism resolves, all calling context registers for embedded network A are pushed to a stack corresponding to embedded network A.
   ∘ For example, an embedded network A may be called from N possible locations within the RTN, i.e. there are N calling edges and N associated calling context registers for embedded network A. All of the N calling contexts stored in these N calling context registers are pushed to the stack (i.e. N bits are pushed to the embedded network A stack).
   ∘ In the case that only one call has been made to embedded network, only a single calling context register will store the value 1, and the remaining calling contest registers will store the value 0.
   ∘ When simultaneous calls have been made to embedded network A from different locations, the set of calling contexts will include multiple values of 1, corresponding to each of the simultaneous calls.
   ∘ In some embodiments, compression techniques may be used. For example, in some cases a binary representation of the set of calling contexts may be used, to reduce the number of bits pushed to the stack.
- Alternatively, if the call to embedded network A dies away (i.e. falls out of state) in the non-deterministic region, the stack is unmodified, and the speculative call is forgotten.
- On return from the recursive call (embedded network A in context X), either:
   ∘ The stack is popped coincident with the return and the popped set of calling contexts is used to return to context X directly, or, ...
   ∘ The stack is popped at a point prior to the return and the popped set of calling contexts is loaded back into the calling context registers for embedded network A. The calling context registers then direct the return from embedded network A to network X as in non-recursive scenarios (e.g. as described above for grammars that abide by Condition 1)

For certain LL(*) grammars, a recursively embedded network may be called again during a parse before the non-determinism has resolved (and before the initial call has. fallen out of state). In such cases, the techniques discussed above for Scenario 1 can be used on that problematic call. For example, duplication can be used for each level of the recursive calling of the embedded network.

### Identifying when to push and pop

In most LL(*) grammars, push and pop operations occur when certain RTN transitions are triggered. Suitable transitions are identified by:
- constructing a DFA for the RTN
- analysing the DFA states to identify all corresponding RTN transitions that are suitable for pushing and popping
- selecting push and pop transitions that satisfy relevant validation criteria

In some LL(*) grammars, it is not possible to find push/pop transitions that occur only once per rule invocation on a successful parse. In such scenarios it is necessary to action the push/pop event in stages using two distinct transitions:
- A first transition is identified and used to "arm" the push/pop action (setting a push/pop arming register)
- A second transition is identified and used to "trigger" the push/pop action provided the corresponding arming register is set (initiating the stack operation and clearing the arming register)

Both the first and second transitions can occur multiple times per rule invocation while the stack operation is only triggered once (provided sequencing criteria hold between the first and second transitions).

The preceding description so far has discussed recursive transition network (RTNs) only. However, the techniques described herein (both for LL(1) grammars and LL(*) grammars) may also be applied to augmented transition networks (ATNs), which also may represent the rules of a grammar, and also may include input-consuming edges and non-input consuming edges, or indeed any other 'transition network' that includes such features and may represent the rules of a grammar.

The preceding discussion describes the generation for a hardware description for configuring a digital electronic circuit to parse input data comprising a sequence of input tokens against a grammar that defines a data format. In such examples, it assumed that the input data has previously been lexed into the sequence of separate input tokens before the digital electronic circuit processes them from the input buffer. The skilled reader should note that some implementations may additionally include a lexing stage within the hardware description to lex any unseparated input data into the sequence of tokens and supply the input tokens to the input buffer for parsing. A resulting digital electronic circuit may include such a lexing stage within the same hardware (e.g. same FPGA device) as the circuitry for parsing the input data in the form of lexed input tokens.

The skilled reader will appreciate that the various illustrative logical blocks, configurations, modules, circuits, and algorithm steps described in connection with the embodiments disclosed herein may be implemented as electronic hardware, computer system software, or combinations of both. To clearly illustrate this interchangeability of hardware and software, various illustrative components, blocks, configurations, modules, circuits, and steps have been described above generally in terms of their functionality. Whether such functionality is implemented as hardware or software depends upon the particular application and design constraints imposed on the overall system. The skilled reader may implement the described functionality in varying ways for each particular application, but such implementation decisions should not be interpreted as causing a departure from the scope of the present disclosure.

The steps of a method or algorithm described in connection with the embodiments disclosed herein may be embodied directly in hardware, in software executed by a processor, or in a combination of the two. If implemented in software, the functions may be stored on or transmitted over, as one or more instructions or code, a computer system-readable medium and executed by a hardware-based processing unit. Computer-readable media may include computer-system-readable storage media, which corresponds to a tangible medium such as data storage media, or communication media including any medium that facilitates transfer of a computer system program from one place to another, e.g., according to a communication protocol. In this manner, computer system-readable media generally may correspond to tangible computer system-readable storage media which is non-transitory or alternatively to a communication medium such as a signal or carrier wave. Data storage media may be any available media that can be accessed by one or more computer systems or one or more processors to retrieve instructions, code and/or data structures for implementation of the techniques described in this disclosure.

The present disclosure makes reference to signals that are 'logical high'. These signals might not necessarily have a higher voltage value than a 'logical low', but instead are intended to refer to a signal representative of 'one' or 'true', as compared with 'zero' or 'false'.

The previous description of the disclosed embodiments is provided to enable any person skilled in the art to make or use the disclosed embodiments. Various modifications to these embodiments will be readily apparent to those skilled in the art, and the principles defined herein may be applied to other embodiments without departing from the scope of the disclosure. Thus, the present disclosure is not intended to be limited to the embodiments shown herein but is to be accorded the widest scope possible consistent with the principles and novel features as defined by the following claims.

The following clauses set out certain combinations of features contemplated by the present disclosure:
1. A computer-implemented method of generating a hardware description for configuring a digital electronic circuit to parse input data against an LL(*) grammar that defines a data format, the input data comprising a sequence of input tokens, the method comprising:
   providing a digitally stored graph representing a transition network based on the rules of the LL(*) grammar, and
   generating the hardware description in a hardware description language or as a netlist based on the transition network,
   wherein the LL(*) grammar is not LL(1),
   wherein the transition network comprises a plurality of networks including at least one embedded network that is embedded within at least one other network of the transition network,
   wherein each of the one or more networks comprises a plurality of vertices and a plurality of directed edges connected between vertices of the network, the plurality of vertices including a start vertex and an end vertex, each directed edge connected between a respective source vertex and destination vertex of the network, wherein the plurality of directed edges of the one or more networks comprises a plurality of input-consuming edges and a plurality of non-input-consuming edges,
   wherein each input-consuming edge represents a transition between its source vertex and its destination vertex conditional on a current input token of the input data matching an input-consumption condition associated with the input-consuming edge, wherein parsing of the input data advances to a next input token of the input data with the transition,
   wherein each non-input-consuming edge represents a transition between its source vertex and its destination vertex without the parsing of the input data advancing to a next input token of the input data with the transition,
   wherein each network within which an embedded network is embedded comprises at least one embedded-network-calling edge and corresponding embedded-network-returning edge, which are non-input-consuming edges,
   wherein, for each embedded-network-calling edge and corresponding embedded-network-returning edge, the source vertex of the embedded-network-calling edge and destination vertex of the embedded-network-returning edge are vertices of a network within which the embedded network is embedded, the destination vertex of the embedded-network-calling edge is the start vertex of the embedded network, and the source vertex of the embedded-network-returning edge is the end vertex of the embedded network,
   wherein the transition network is such that for all input data that conforms to the LL(*) grammar, during parsing of the input data against the grammar, after a first embedded-network-calling edge to any embedded network within the transition network is transitioned, no embedded-network-calling edges to that embedded network are subsequently transitioned until either the embedded-network-returning edge corresponding to the first embedded-network-calling edge has been transitioned or the parse reaches a state where no input-consuming edge within that embedded network can be transitioned for the next input token,
   wherein generating the hardware description comprises implementing an input buffer in the hardware description to store a sequence of input tokens of the input data, the input buffer configured to provide an input token of the sequence of input tokens as output from the input buffer, wherein the input buffer is further configured to sequentially advance through the sequence of input tokens by, on a clock tick, providing a next input token as output from the input buffer,
   wherein generating the hardware description comprises further implementing circuitry in the hardware description for the edges and vertices of the transition network,
   wherein the implemented circuitry for each vertex is electrically connected to the implemented circuitry for each edge that is connected to the vertex in the transition network, the implemented circuitry for each vertex configured to output a logical high to circuitry for all outgoing directed edges of that vertex if circuitry for an incoming directed edge of that vertex provides a logical high,
   wherein the implemented circuitry for each input-consuming edge comprises a register with associated logic configured to compare an input token provided as output from the input buffer with the input-consumption condition associated with that input-consuming edge, the register with associated logic configured to, if the implemented circuitry for the source vertex of the input-consuming edge provides a logical high and the input token provided as output from the input buffer satisfies the input-consumption condition of the input-consuming edge, provide a logical high to circuitry for the destination vertex of the input-consuming edge on a next clock tick, the input buffer advancing to a next input token and providing the next input token as output from the input buffer on said next clock tick,
   wherein the implemented circuitry for each non-input-consuming edge comprises a coupling between circuitry for the source vertex of the non-input-consuming edge and circuitry for the destination vertex of the non-input-consuming edge,
   wherein the implemented circuitry for each embedded-network-calling edge further comprises logic to, in response to one or more calling-edge conditions associated with that edge all being satisfied, provide a logical high to the implemented circuitry for the destination vertex of that edge and store a value in a memory associated with that embedded-network-calling edge, the value indicative of that embedded-network-calling edge having been transitioned, the one or more calling-edge conditions associated with that edge including a requirement that the implemented circuitry for the source vertex of that edge provides a logical high,
   wherein the implemented circuitry for each embedded-network-returning edge further comprises logic to, in response to a plurality of returning-edge conditions associated with that edge all being satisfied, provide a logical high to the implemented circuitry for the destination vertex of that edge, the plurality of returning-edge conditions associated with that edge including: a requirement that the implemented circuitry for the source vertex of that edge provides a logical high and a requirement that the memory associated with the corresponding embedded-network-calling edge for that embedded-network-returning edge has stored thereon the value indicative of that corresponding embedded-network-calling edge having been transitioned.
2. The method of clause 1, wherein the one or more calling-edge conditions associated with at least one embedded-network-calling edge further include a requirement that the input token provided as output from the input buffer satisfies an input-consumption condition associated with a next input-consuming edge downstream of the destination vertex of that embedded-network-calling edge.
3. The method of clause 1 or clause 2, wherein the plurality of returning-edge conditions associated with at least one embedded-network-returning edge further include a requirement that the input token provided as output from the input buffer satisfies an input-consumption condition associated with a next input-consuming edge downstream of the destination vertex of that embedded-network-returning edge.
4. The method of any preceding clause, wherein an embedded network is embedded in multiple locations within a network of the transition network using separate embedded-network-calling edges connected to the start vertex of the embedded network from different vertices and using separate corresponding embedded-network-returning edges connected from the end vertex of the embedded network to different vertices.
5. The method of any preceding clause, wherein an embedded network is embedded within more than one network of the plurality of networks.
6. The method of any preceding clause, wherein the memory associated with each embedded-network-calling edge comprises a register to store the value indicative of that embedded-network-calling edge having been transitioned.
7. The method of any preceding clause, wherein each embedded-network-calling edge has a separate dedicated associated memory.
8. The method of any preceding clause, wherein for at least one embedded-network-calling edge, the memory associated with that embedded-network-calling edge is configured to store a first value, such as 1, as the value indicative of that embedded-network-calling edge having been transitioned.
9. The method of any preceding clause, wherein for at least one embedded-network-calling edge, the memory associated with that embedded-network-calling edge is configured to store a value indicative of the corresponding embedded-network-returning edge for that embedded-network-calling edge as the value indicative of that embedded-network-calling edge having been transitioned.
10. The method of any preceding clause, wherein the implemented circuitry for each embedded-network-calling edge is further configured to overwrite any previous value stored in the memory associated with that that embedded-network-calling edge when storing the value indicative of that embedded-network-calling edge having been transitioned.
11. The method of any preceding clause, wherein the implemented circuitry for each embedded-network-calling edge is further configured to, in response to one or more calling-edge conditions associated with that edge all being satisfied, clear any previous values stored in any memory associated with any other embedded-network-calling edge that has the same destination vertex.
12. The method of any clause 11, wherein clearing any previous values stored in any memory associated with any other embedded-network-calling edge that has the same destination vertex comprises overwriting said previous values by storing a second value, such as 0.
13. The method of any preceding clause, wherein at least one vertex of a network of the transition network has a plurality of incoming directed edges and the implemented circuitry for the vertex comprises a logical OR gate, wherein the implemented circuitry for each of the plurality of incoming directed edges of the vertex is electrically connected as an input to the logical OR gate.
14. The method of any preceding clause, wherein generating the hardware description comprises implementing a lexer in the hardware description, wherein the implemented lexer is configured to lex input data into a sequence of input tokens to be provided to the input buffer.
15. The method of any preceding clause, wherein providing the digitally stored graph representing the transition network comprises processing a digitally stored graph representing an initial transition network by performing one or more of the following operations:
   - ensuring that edges connected to or from an embedded network are non-input-consuming edges, and
   - inlining an embedded network.
16. The method of clause 15, wherein ensuring that edges connected to or from an embedded network are non-input-consuming edges comprises, for each embedded network of the initial transition network, if an edge connected to or from the embedded network is an input-consuming edge, inserting a new vertex and a new non-input consuming edge between the input-consuming edge and the embedded network.
17. The method of any preceding clause, wherein the LL(*) grammar defines a data format that comprises: i) a JSON schema, or ii) an XML Schema Definition, XSD, or iii) an ASN.1 schema.
18. The method of any preceding clause, wherein the hardware description for configuring the digital electronic circuit is generated in Verilog or VHDL.
19. The method of any preceding clause, wherein the transition network is a recursive transition network, RTN.
20. The method of clause 19, wherein providing the digitally stored graph representing the RTN comprises constructing the RTN based on an augmented transition network, ATN, that corresponds to the rules of the LL(*) grammar, the ATN comprising one or more actions and conditions, the RTN constructed by removing the one or more actions and conditions from the ATN.
21. A computer-implemented method of generating a hardware description for configuring a digital electronic circuit to parse input data against an LL(*) grammar that defines a data format, the input data comprising a sequence of input tokens, the method comprising:
   providing a digitally stored graph representing a transition network based on the rules of the LL(*) grammar, and
   generating the hardware description in a hardware description language or as a netlist based on the transition network,
   wherein the LL(*) grammar is not LL(1),
   wherein the transition network comprises a plurality of vertices and a plurality of directed edges connected between vertices of the network, the plurality of vertices including a start vertex and an end vertex, each directed edge connected between a respective source vertex and destination vertex of the network, wherein the plurality of directed edges of the transition network comprises a plurality of input-consuming edges and a plurality of non-input-consuming edges,
   wherein each input-consuming edge represents a transition between its source vertex and its destination vertex conditional on a current input token of the input data matching an input-consumption condition associated with the input-consuming edge, wherein parsing of the input data advances to a next input token of the input data with the transition,
   wherein each non-input-consuming edge represents a transition between its source vertex and its destination vertex without the parsing of the input data advancing to a next input token of the input data with the transition,
   wherein generating the hardware description comprises implementing an input buffer in the hardware description to store a sequence of input tokens of the input data, the input buffer configured to provide an input token of the sequence of input tokens as output from the input buffer, wherein the input buffer is further configured to sequentially advance through the sequence of input tokens by, on a clock tick, providing a next input token as output from the input buffer,
   wherein generating the hardware description comprises further implementing circuitry in the hardware description for the edges and vertices of the transition network,
   wherein the implemented circuitry for each vertex is electrically connected to the implemented circuitry for each edge that is connected to the vertex in the transition network, the implemented circuitry for each vertex configured to output a logical high to circuitry for all outgoing directed edges of that vertex if circuitry for an incoming directed edge of that vertex provides a logical high,
   wherein the implemented circuitry for each input-consuming edge comprises a register with associated logic configured to compare an input token provided as output from the input buffer with the input-consumption condition associated with that input-consuming edge, the register with associated logic configured to, if the implemented circuitry for the source vertex of the input-consuming edge provides a logical high and the input token provided as output from the input buffer satisfies the input-consumption condition of the input-consuming edge, provide a logical high to circuitry for the destination vertex of the input-consuming edge on a next clock tick, the input buffer advancing to a next input token and providing the next input token as output from the input buffer on said next clock tick,
   wherein the implemented circuitry for each non-input-consuming edge comprises a coupling between circuitry for the source vertex of the non-input-consuming edge and circuitry for the destination vertex of the non-input-consuming edge.
22. The method of clause 21, wherein the transition network does not include any embedded networks.
23. A computer-implemented method of generating a hardware description for configuring a digital electronic circuit to parse input data against an LL(*) grammar that defines a data format, the input data comprising a sequence of input tokens, the method comprising:
   providing a digitally stored graph representing a transition network based on the rules of the LL(*) grammar; and
   generating the hardware description in a hardware description language or as a netlist based on the transition network;
   wherein the LL(*) grammar is not LL(1).
24. The method of clause 23, wherein either:
   the transition network does not include any embedded networks, or
   the transition network is such that for all input data that conforms to the LL(*) grammar, during parsing of the input data against the grammar, after a first embedded-network-calling edge to any embedded network within the transition network is transitioned, no embedded-network-calling edges to that embedded network are subsequently transitioned until either the embedded-network-returning edge corresponding to the first embedded-network-calling edge has been transitioned or the parse reaches a state where no input-consuming edge within that embedded network can be transitioned for the next input token.
25. A method of configuring a digital electronic circuit to parse input data, the method comprising:
   generating a hardware description in accordance with any of clauses 1 to 24; and
   configuring a digital electronic circuit based on the hardware description.
26. The method of clause 25, wherein the digital electronic circuit is an application-specific integrated circuit, ASIC, or a field-programmable gate array, FPGA.
27. A digital electronic circuit produced according to the method of clause 25 or clause 26.

## Claims

1. A computer-implemented method of generating a hardware description for configuring a digital electronic circuit to parse input data against an LL(*) grammar that defines a data format, the input data comprising a sequence of input tokens, the method comprising:
providing a digitally stored graph representing a transition network based on the rules of the LL(*) grammar; and
generating the hardware description in a hardware description language or as a netlist based on the transition network;
wherein the LL(*) grammar is not LL(1).

2. The method of claim 1, wherein the transition network comprises a plurality of vertices and a plurality of directed edges connected between vertices of the network, the plurality of vertices including a start vertex and an end vertex, each directed edge connected between a respective source vertex and destination vertex of the network, wherein the plurality of directed edges of the transition network comprises a plurality of input-consuming edges and a plurality of non-input-consuming edges,
wherein each input-consuming edge represents a transition between its source vertex and its destination vertex conditional on a current input token of the input data matching an input-consumption condition associated with the input-consuming edge, wherein parsing of the input data advances to a next input token of the input data with the transition,
wherein each non-input-consuming edge represents a transition between its source vertex and its destination vertex without the parsing of the input data advancing to a next input token of the input data with the transition,
wherein generating the hardware description comprises implementing an input buffer in the hardware description to store a sequence of input tokens of the input data, the input buffer configured to provide an input token of the sequence of input tokens as output from the input buffer, wherein the input buffer is further configured to sequentially advance through the sequence of input tokens by, on a clock tick, providing a next input token as output from the input buffer,
wherein generating the hardware description comprises further implementing circuitry in the hardware description for the edges and vertices of the transition network,
wherein the implemented circuitry for each vertex is electrically connected to the implemented circuitry for each edge that is connected to the vertex in the transition network, the implemented circuitry for each vertex configured to output a logical high to circuitry for all outgoing directed edges of that vertex if circuitry for an incoming directed edge of that vertex provides a logical high,
wherein the implemented circuitry for each input-consuming edge comprises a register with associated logic configured to compare an input token provided as output from the input buffer with the input-consumption condition associated with that input-consuming edge, the register with associated logic configured to, if the implemented circuitry for the source vertex of the input-consuming edge provides a logical high and the input token provided as output from the input buffer satisfies the input-consumption condition of the input-consuming edge, provide a logical high to circuitry for the destination vertex of the input-consuming edge on a next clock tick, the input buffer advancing to a next input token and providing the next input token as output from the input buffer on said next clock tick,
wherein the implemented circuitry for each non-input-consuming edge comprises a coupling between circuitry for the source vertex of the non-input-consuming edge and circuitry for the destination vertex of the non-input-consuming edge.

3. The method of claim 2, wherein the transition network comprises a plurality of networks including at least one embedded network that is embedded within at least one other network of the transition network,
wherein each of the one or more networks comprises a plurality of vertices and a plurality of directed edges connected between vertices of the network, the plurality of vertices including a start vertex and an end vertex, each directed edge connected between a respective source vertex and destination vertex of the network, wherein the plurality of directed edges of the one or more networks comprises a plurality of input-consuming edges and a plurality of non-input-consuming edges,
wherein each network within which an embedded network is embedded comprises at least one embedded-network-calling edge and corresponding embedded-network-returning edge, which are non-input-consuming edges,
wherein, for each embedded-network-calling edge and corresponding embedded-network-returning edge, the source vertex of the embedded-network-calling edge and destination vertex of the embedded-network-returning edge are vertices of a network within which the embedded network is embedded, the destination vertex of the embedded-network-calling edge is the start vertex of the embedded network, and the source vertex of the embedded-network-returning edge is the end vertex of the embedded network,
wherein the transition network is such that for all input data that conforms to the LL(*) grammar, during parsing of the input data against the grammar, after a first embedded-network-calling edge to any embedded network within the transition network is transitioned, no embedded-network-calling edges to that embedded network are subsequently transitioned until either the embedded-network-returning edge corresponding to the first embedded-network-calling edge has been transitioned or the parse reaches a state where no input-consuming edge within that embedded network can be transitioned for the next input token,
wherein the implemented circuitry for each embedded-network-calling edge further comprises logic to, in response to one or more calling-edge conditions associated with that edge all being satisfied, provide a logical high to the implemented circuitry for the destination vertex of that edge and store a value in a memory associated with that embedded-network-calling edge, the value indicative of that embedded-network-calling edge having been transitioned, the one or more calling-edge conditions associated with that edge including a requirement that the implemented circuitry for the source vertex of that edge provides a logical high,
wherein the implemented circuitry for each embedded-network-returning edge further comprises logic to, in response to a plurality of returning-edge conditions associated with that edge all being satisfied, provide a logical high to the implemented circuitry for the destination vertex of that edge, the plurality of returning-edge conditions associated with that edge including: a requirement that the implemented circuitry for the source vertex of that edge provides a logical high and a requirement that the memory associated with the corresponding embedded-network-calling edge for that embedded-network-returning edge has stored thereon the value indicative of that corresponding embedded-network-calling edge having been transitioned.

4. The method of claim 3, wherein the one or more calling-edge conditions associated with at least one embedded-network-calling edge further include a requirement that the input token provided as output from the input buffer satisfies an input-consumption condition associated with a next input-consuming edge downstream of the destination vertex of that embedded-network-calling edge.

5. The method of claim 3 or claim 4, wherein the plurality of returning-edge conditions associated with at least one embedded-network-returning edge further include a requirement that the input token provided as output from the input buffer satisfies an input-consumption condition associated with a next input-consuming edge downstream of the destination vertex of that embedded-network-returning edge.

6. The method of any of claims 3 to 5, wherein:
an embedded network is embedded in multiple locations within a network of the transition network using separate embedded-network-calling edges connected to the start vertex of the embedded network from different vertices and using separate corresponding embedded-network-returning edges connected from the end vertex of the embedded network to different vertices; and/or
an embedded network is embedded within more than one network of the plurality of networks.

7. The method of any of claims 3 to 6, wherein the memory associated with each embedded-network-calling edge comprises a register to store the value indicative of that embedded-network-calling edge having been transitioned.

8. The method of any of claims 3 to 7, wherein each embedded-network-calling edge has a separate dedicated associated memory.

9. The method of any of claims 3 to 8, wherein for at least one embedded-network-calling edge, the memory associated with that embedded-network-calling edge is configured to:
store a first value, such as 1, as the value indicative of that embedded-network-calling edge having been transitioned; or
store a value indicative of the corresponding embedded-network-returning edge for that embedded-network-calling edge as the value indicative of that embedded-network-calling edge having been transitioned.

10. The method of any of claims 3 to 9, wherein the implemented circuitry for each embedded-network-calling edge is further configured to:
overwrite any previous value stored in the memory associated with that that embedded-network-calling edge when storing the value indicative of that embedded-network-calling edge having been transitioned; and/or
in response to one or more calling-edge conditions associated with that edge all being satisfied, clear any previous values stored in any memory associated with any other embedded-network-calling edge that has the same destination vertex.

11. The method of any of claims 2 to 10, wherein at least one vertex of a network of the transition network has a plurality of incoming directed edges and the implemented circuitry for the vertex comprises a logical OR gate, wherein the implemented circuitry for each of the plurality of incoming directed edges of the vertex is electrically connected as an input to the logical OR gate.

12. The method of any preceding claim, wherein providing the digitally stored graph representing the transition network comprises processing a digitally stored graph representing an initial transition network by performing one or more of the following operations:
• ensuring that edges connected to or from an embedded network are non-input-consuming edges, and
• inlining an embedded network.

13. The method of any preceding claim, wherein the LL(*) grammar defines a data format that comprises: i) a JSON schema, or ii) an XML Schema Definition, XSD, or iii) an ASN.1 schema.

14. A method of configuring a digital electronic circuit to parse input data, the method comprising:
generating a hardware description in accordance with any of claims 1 to 13; and
configuring a digital electronic circuit based on the hardware description.

15. A digital electronic circuit produced according to the method of claim 14.
